# EUROPEAN PATENT APPLICATION

(11) **EP 4 622 425 A1**
(43) Date of publication of application: **24.09.2025**
(21) Application number: 25720617.7
(22) Date of filing: 15.01.2025
(51) Int. Cl.: H10F 77/20, H10F 10/14, H10F 71/00

(54) **BACK-CONTACT CELL AND MANUFACTURING METHOD THEREFOR**

(30) Priority: 26.01.2024 CN 202410111958
(71) Applicant: LONGi Green Energy Technology Co., Ltd., Xi'an, Shaanxi 710100 (CN)
(72) Inventor: LI, Zhenguo, Xi'an Shaanxi 710100 (CN); TONG, Hongbo, Xi'an Shaanxi 710100 (CN); LIU, Qingping, Xi'an Shaanxi 710100 (CN); DING, Chao, Xi'an Shaanxi 710100 (CN); ZHANG, Hongchao, Xi'an Shaanxi 710100 (CN); CHEN, Chen, Xi'an Shaanxi 710100 (CN); DONG, Guangbin, Xi'an Shaanxi 710100 (CN); XU, Xinxing, Xi'an Shaanxi 710100 (CN); WANG, Yanzeng, Xi'an Shaanxi 710100 (CN)
(74) Representative: Pfenning, Meinig & Partner mbB
(86) International application number: PCT/CN2025/072473
(87) International publication number: WO 2025/157046

(57) **Abstract**

The present application discloses a back contact solar cell and a manufacturing method therefor, and relates to the field of photovoltaic technology, so as to improve a surface passivation effect of a surface passivation layer on a back surface of a silicon substrate, and reduce the carrier recombination rate on a back surface of the back contact solar cell. The back contact solar cell includes: a silicon substrate, a first doped semiconductor layer, a second doped semiconductor layer, and a surface passivation layer. On the back surface of the silicon substrate, regions corresponding to the first doped semiconductor layer are first regions, regions corresponding to the second doped semiconductor layer are second regions, and regions between the first regions and the adjacent second regions are interval regions. The interval regions adjacent to the first doped semiconductor layer are first interval sub-regions, and the other interval regions are second interval sub-regions. Surfaces of the first interval sub-regions are flat surfaces. The surface passivation layer covers the first doped semiconductor layer, the second doped semiconductor layer, and the interval regions.

## Description

### TECHNICAL FIELD

The present application relates to the field of photovoltaic technology, and particularly relates to a back contact solar cell and a manufacturing method therefor.

### BACKGROUND

A back contact solar cell is a solar cell with a light receiving surface free of electrodes and a back surface equipped with positive and negative electrodes. Thus, the cell can be less blocked by the electrodes, the short-circuit current of the cell can be increased, and energy conversion efficiency of the cell can be improved. In addition, a surface passivation layer may be formed on the back surface of the back contact solar cell, so as to reduce the carrier recombination rate on the back surface of the back contact solar cell, and improve photoelectric conversion efficiency of the back contact solar cell.

However, the passivation effect of the surface passivation layer on the back surface in conventional back contact solar cells is poor, which is not conducive to improvement in the photoelectric conversion efficiency of the back contact solar cell.

### SUMMARY

An objective of the present application is to provide a back contact solar cell and a manufacturing method therefor, so as to improve a surface passivation effect of a surface passivation layer on a back surface of a silicon substrate, reduce the carrier recombination rate on a back surface of the back contact solar cell, and improve photoelectric conversion efficiency of the back contact solar cell.

To achieve the objective, according to a first aspect, the present application provides a back contact solar cell. The back contact solar cell includes: a silicon substrate, a first doped semiconductor layer, a second doped semiconductor layer, and a surface passivation layer. The first doped semiconductor layer and the second doped semiconductor layer are alternately distributed at intervals on a back surface of the silicon substrate in a direction parallel to the silicon substrate. A conduction type of the first doped semiconductor layer is opposite to that of the second doped semiconductor layer. On the back surface of the silicon substrate, regions corresponding to the first doped semiconductor layer are first regions, regions corresponding to the second doped semiconductor layer are second regions, and regions between the first regions and the adjacent second regions are interval regions. In an arrangement direction of the first regions and the second regions, the interval regions adjacent to the first doped semiconductor layer are first interval sub-regions, and the other interval regions are second interval sub-regions. Surfaces of the first interval sub-regions and surfaces of the second regions are concave toward an interior of the silicon substrate relative to surfaces of the first regions, and surfaces of the second interval sub-regions are concave toward an interior of the silicon substrate relative to the surfaces of the first interval sub-regions. The surfaces of the first interval sub-regions are flat surfaces. The surface passivation layer covers the first doped semiconductor layer, the second doped semiconductor layer, and the interval regions.

Through the technical solution, in the back contact solar cell provided by the present application, the first doped semiconductor layer and the second doped semiconductor layer having opposite conduction types are alternately distributed at intervals on the back surface of the silicon substrate in the direction parallel to the silicon substrate. Based on this, the interval regions on the back surface of the silicon substrate may separate the first doped semiconductor layer from the second doped semiconductor layer, such that the carrier recombination rate at lateral interfaces of the first doped semiconductor layer and the second doped semiconductor layer is reduced, and photoelectric conversion efficiency of the back contact solar cell is improved. The interval regions adjacent to the first regions are the first interval sub-regions, and the other interval regions are the second interval sub-regions. In addition, the surfaces of the first interval sub-regions and the surfaces of the second regions are concave toward the interior of the silicon substrate relative to the surfaces of the first regions, and the surfaces of the second interval sub-regions are concave toward the interior of the silicon substrate relative to the surfaces of the first interval sub-regions. In this case, the first doped semiconductor layer is formed on the first regions of the back surface, and the second doped semiconductor layer is formed on the second regions of the back surface. Thus, when the surfaces of the second regions are concave toward the interior of the silicon substrate relative to the surfaces of the first regions, the first doped semiconductor layer and the second doped semiconductor layer that are located on the back surface of the silicon substrate and have the opposite conduction types are at least partially staggered in a thickness direction of the silicon substrate. Further, a risk of electric leakage on the back surface is reduced, and electrical reliability of the back contact solar cell is improved.

In addition, the back contact solar cell provided by the present application further includes the surface passivation layer covering the first doped semiconductor layer, the second doped semiconductor layer, and the interval regions, such that chemical passivation is conducted on the back surface of the first doped semiconductor layer and the second doped semiconductor layer and the interval regions, and the carrier recombination rate is reduced. Based on this, the first interval sub-regions have flat surfaces. Compared with a textured surface, the flat surface has a smaller specific surface area. However, within a particular range, a thickness of the surface passivation layer is inversely proportional to a specific surface area of a surface located under the surface passivation layer, and the passivation effect of the surface passivation layer is proportional to the thickness of the surface passivation layer. Thus, a thickness of the surface passivation layer formed on the first interval sub-regions is greater than a thickness of the surface passivation layer formed on the textured surface, and accordingly, the passivation effect of the surface passivation layer on the first interval sub-regions is greater than that of the surface passivation layer on the textured surface. In this case, compared with a conventional back contact solar cell in which surfaces of all regions of interval regions are textured surfaces, in the back contact solar cell provided by the present application, at least the first interval sub-regions included in the interval regions have flat surfaces. In this case, the surface passivation layer has a higher surface passivation effect on the first interval sub-regions, such that the carrier recombination rate on the first interval sub-regions can be further reduced, and the photoelectric conversion efficiency of the back contact solar cell can be further improved.

In a possible embodiment, in the arrangement direction of the first regions and the second regions, a length of the interval region is greater than or equal to 20 µm and less than or equal to 110 µm.

Through the technical solution, the length of the interval region is within the range, such that electric leakage between the first doped semiconductor layer and the second doped semiconductor layer due to a small distance can be prevented, and high electrical reliability of the back contact solar cell can be ensured. In addition, the situation that carriers on the back surface fail to be collected by the first doped semiconductor layer and/or the second doped semiconductor layer in time and exported by corresponding electrodes due to a small forming range of the first doped semiconductor layer and/or the second doped semiconductor layer on the back surface because of a great distance can be prevented, and further the carrier recombination rate on the back surface can be reduced.

In a possible embodiment, in the arrangement direction of the first regions and the second regions, a length of the first interval sub-region is greater than or equal to 1000 nm and less than or equal to 3000 nm.

Through the technical solution, the length of the first interval sub-region is within the range, such that insignificant improvement in the passivation effect of the surface passivation layer on the interval regions due to a small length of the first interval sub-region can be prevented, and a low carrier recombination rate on the back surface can be ensured. In addition, in an actual manufacturing process, the first interval sub-regions have the flat surfaces due to suspended ends, at least located above the first interval sub-regions, of the first doped semiconductor layer in a formation procedure of the second doped semiconductor layer (the suspended ends may be removed before the surface passivation layer is formed). Under a protection effect of the suspended ends, a corresponding erosion solution conducts erosion on only the second interval sub-regions, and a phenomenon of a bumpy surface caused by excessive etching or other factors due to influence of the erosion solution on the surfaces of the first interval sub-regions can be avoided. Based on this, the length of the first interval sub-region is within the range, such that greater manufacturing difficulty caused by a requirement of forming the suspended end having a greater length in a manufacturing process due to a greater length of the first interval sub-region can be prevented, and manufacturing difficulty of the back contact solar cell can be reduced.

In a possible embodiment, the surfaces of the first interval sub-regions are flush with the surfaces of the second regions.

Through the technical solution, in an actual manufacturing process, after the first doped semiconductor layer integrally arranged is formed on the back surface, the first doped semiconductor layer needs to be selectively etched. After selective etching, the surfaces of the interval regions and the second regions are concave inward relative to the surface of the first regions with an identical concave depth. Based on this, when the surfaces of the first interval sub-regions are flush with the surfaces of the second regions, that is, when depths by which the surfaces of the first interval sub-regions and the second regions are concave toward the interior of the silicon substrate are identical, it is unnecessary to re-conduct selective etching on the first interval sub-regions or the second regions after conducting selective etching on the first doped semiconductor layer. In this way, a selected material thickness of the silicon substrate can further be reduced while a manufacturing process of the back contact solar cell can be simplified, and thinning production can be facilitated.

In a possible embodiment, a depth by which the surfaces of the first interval sub-regions are concave toward the interior of the silicon substrate is greater than or equal to 500 nm and less than or equal to 2500 nm relative to the surface of the first region.

Through the technical solution, the depth by which the surfaces of the first interval sub-regions are concave toward the interior of the silicon substrate is within the range, such that a small staggering degree between the first doped semiconductor layer and the second doped semiconductor layer that are located on the back surface of the silicon substrate and have the opposite conduction types in the thickness direction of the silicon substrate due to a small thickness can be prevented, and further the risk of electric leakage on the back surface can be reduced. In addition, in an actual manufacturing process, the recess structures that are concave toward the interior of the silicon substrate relative to the surfaces of the first regions are formed on the interval regions and the second regions on the back surface of the silicon substrate, such that an end of the first doped semiconductor layer adjacent to the interval regions is suspended, and the surfaces of the first interval sub-regions are concave toward the interior of the silicon substrate. Based on this, the depth by which the surfaces of the first interval sub-regions are concave toward the interior of the silicon substrate is within the range, such that a smaller length of the end suspended on the interval region (further a smaller length of the first interval sub-region) due to influence of an etching solution etching the silicon substrate on the suspended end of the first doped semiconductor layer because of a great depth of the recess structure can be prevented, and a higher passivation effect of the surface passivation layer on the interval regions can be ensured. Further, a requirement of using a thick silicon substrate due to a great depth of the recess structure can be prevented. Thus, thinning production of the back contact solar cell can be facilitated while manufacturing cost of the back contact solar cell can be reduced.

In a possible embodiment, the surfaces of the second interval sub-regions are the textured surfaces. In this case, the textured surfaces have a light trapping function. Thus, when the surfaces of the second interval sub-regions are the textured surfaces, more light may be refracted into the silicon substrate via the surface of the second interval sub-regions, and photoelectric conversion efficiency of the back contact solar cell can be further improved.

In a possible embodiment, a depth by which the surfaces of the second interval sub-regions are concave toward the interior of the silicon substrate is greater than or equal to 3 µm and less than or equal to 5 µm relative to the surface of the first region.

Through the technical solution, in an actual manufacturing process, after the first doped semiconductor layer is formed and the recess structures are formed on the second regions and the interval regions, the second doped semiconductor layer may be deposited on the back surface, and the second doped semiconductor layer may be selectively etched. To prevent electric leakage, generally, after part of the second doped semiconductor layer on the second interval sub-regions is removed, downward etching may continue to be conducted for a specific depth, such that the part of the second doped semiconductor layer on the second interval sub-regions can be ensured to be completely removed. Based on this, the depth by which the surfaces of the second interval sub-regions are concave toward the interior of the silicon substrate is within the range, such that a high risk of electric leakage between the first doped semiconductor layer and the second doped semiconductor layer having the opposite conduction types due to the small depth can be prevented, and high electrical reliability of the back contact solar cell can be ensured. In addition, it may be understood that, the greater depth by which the surfaces of the second interval sub-regions are concave toward the interior of the silicon substrate corresponds to longer erosion time of the erosion solution and greater influence of the erosion solution on another structure. Based on this, the depth by which the surfaces of the second interval sub-regions are concave toward the interior of the silicon substrate is within the range, such that a smaller length of the suspended end of the first doped semiconductor layer and the first interval sub-region due to influence of the erosion solution because of the great depth can be prevented, and a higher passivation effect of the surface passivation layer on the interval regions can be ensured. Further, a requirement of using a thick silicon substrate due to a great depth by which the surfaces of the second interval sub-regions are concave toward the interior of the silicon substrate can be prevented. Thus, thinning production of the back contact solar cell can be facilitated while manufacturing cost of the back contact solar cell can be reduced.

In a possible embodiment, a surface of at least part of a side wall of the interval region adjacent to the first doped semiconductor layer is arranged obliquely relative to a horizontal plane, and a cross-sectional area of at least part of the interval regions gradually increases in a direction from a light receiving surface to the back surface.

Through the technical solution, a cross-sectional area of one side of the interval regions close to the light receiving surface is smaller than that of one side of the interval regions close to the back surface, such that a distance between the first doped semiconductor layer and the second doped semiconductor layer having the opposite conduction types is increased. Thus, a risk of electric leakage on the back surface of the back contact solar cell is reduced, and high electrical reliability of the back contact solar cell is ensured. In addition, the part, arranged obliquely relative to the plane, of the side wall of the interval regions adjacent to the first doped semiconductor layer is conducive to light reflection. Thus, more light enters the silicon substrate from the back surface of the back contact solar cell under a reflection effect of the part, arranged obliquely relative to the plane, of the side walls of the interval regions adjacent to the first doped semiconductor layer, and further the photoelectric conversion efficiency of the back contact solar cell is improved.

In a possible embodiment, in the side walls of the interval regions adjacent to the first doped semiconductor layer, the surface of part of the side wall close to the back surface is arranged perpendicular to the horizontal plane. In this case, in the back contact solar cell provided by the present application, a shape of part of the interval regions adjacent to the first doped semiconductor layer provides another possible embodiment, such that applicability of the back contact solar cell provided by the present application in different application scenes is improved.

In a possible embodiment, the back contact solar cell further includes first passivation layer located between the first regions of the silicon substrate and the first doped semiconductor layer.

Through the technical solution, the first passivation layer and the first doped semiconductor layer may constitute selective contact structures, such that chemical passivation and selective collection are conducted on the first regions included in the back surface of the silicon substrate and the carriers having the corresponding conduction type respectively, the carrier recombination rate on the back surface is reduced, and the photoelectric conversion efficiency of the back contact solar cell is improved.

In a possible embodiment, the back contact solar cell further includes a second passivation layer located between the second regions of the silicon substrate and the second doped semiconductor layer.

Through the technical solution, the second passivation layer and the second doped semiconductor layer may constitute selective contact structures, such that chemical passivation and selective collection are conducted on the second regions included in the back surface of the silicon substrate and the carriers having the corresponding conduction type respectively, the carrier recombination rate on the back surface is reduced, and the photoelectric conversion efficiency of the back contact solar cell is improved.

In a possible embodiment, when the back contact solar cell includes the first passivation layer and the first passivation layer is a tunneling passivation layer, the first doped semiconductor layer is a doped polycrystalline silicon layer.

In a possible embodiment, when the back contact solar cell includes the second passivation layer and the second passivation layer is a tunneling passivation layer, the second doped semiconductor layer is a doped polycrystalline silicon layer.

According to a second aspect, the present application provides a manufacturing method for a back contact solar cell. The manufacturing method for a back contact solar cell includes the following steps: firstly, providing a silicon substrate, where first regions and second regions alternately distributed at intervals and interval regions located between the first regions and the adjacent second regions are provided on a back surface of the silicon substrate in a direction parallel to the silicon substrate; and in an arrangement direction of the first regions and the second regions, the interval regions adjacent to the first regions are first interval sub-regions, and the other interval regions are second interval sub-regions; then, forming a first doped semiconductor layer on the first regions and the first interval sub-regions; forming recess structures that are concave toward an interior of the silicon substrate on the interval regions and the second regions, and suspending ends of the first doped semiconductor layer adjacent to the interval regions, where recess bottoms of the recess structures are flat surfaces; then, depositing a second doped semiconductor layer on the first doped semiconductor layer and in the recess structures, and forming a first mask layer on part of the second doped semiconductor layer in the second regions; then, selectively removing part of the second doped semiconductor layer on the first regions and the interval regions under a masking action of the first mask layer, and causing surfaces of the second interval sub-regions that are concave toward the interior of the silicon substrate relative to a surface of the first interval sub-region; then, removing suspended ends of the first doped semiconductor layer; removing the first mask layer; and then, forming a surface passivation layer covering the first doped semiconductor layer, the second doped semiconductor layer, and the interval regions.

In a possible embodiment, after the providing a silicon substrate, and before the depositing a second doped semiconductor layer on the first doped semiconductor layer and in the recess structures, the manufacturing method for a back contact solar cell further includes the following steps: forming the first doped semiconductor layer integrally arranged on the back surface of the silicon substrate, and arranging a second mask layer on part of the first doped semiconductor layer on the first regions and the first interval sub-regions; then, selectively removing part of the first doped semiconductor layer on the second interval sub-regions and the second regions under a masking action of the second mask layer; and then, forming the recess structures on the interval regions and the second regions under the masking action of the second mask layer.

In a possible embodiment, a material of the first doped semiconductor layer includes silicon. In addition, the forming the first doped semiconductor layer integrally arranged on the back surface of the silicon substrate, and arranging a second mask layer on part of the first doped semiconductor layer on the first regions and the first interval sub-regions include: forming a first intrinsic semiconductor layer integrally arranged on the back surface of the silicon substrate; then, conducting doping treatment on the first intrinsic semiconductor layer, forming the first doped semiconductor layer on the first intrinsic semiconductor layer, and forming a first doped silica glass layer integrally arranged on the first doped semiconductor layer; then, conducting heat treatment on part of the first doped silica glass layer on the second interval sub-regions and the second regions through a laser etching process, and forming the second mask layer on part (that is, part on the first regions and the first interval sub-regions), not subjected to the heat treatment, of the first doped silica glass layer; and then, removing part, subjected to the heat treatment, of the first doped silica glass layer.

Through the technical solution, when the material of the first doped semiconductor layer includes silicon, a material of the first intrinsic semiconductor layer used to manufacture the first doped semiconductor layer includes silicon. Based on this, after doping treatment is conducted on the first intrinsic semiconductor layer, the first doped semiconductor layer can be obtained, and the first doped silica glass layer integrally arranged can be formed on the first doped semiconductor layer. Then, heat treatment is conducted on part of the first doped silica glass layer through the laser etching process. In this case, part, subjected to laser treatment, of the first doped silica glass layer has a lower density and is easy to remove. Part, not subjected to laser treatment, of the first doped silica glass layer has a higher density and is uneasy to remove. Thus, after the heat treatment, different parts of the first doped silica glass layer have different etching selection ratios, and the second mask layer for patterning the first doped semiconductor layer is obtained. It is unnecessary to additionally form other mask materials and other mask deposition procedures so as to obtain the second mask layer. In this way, manufacturing cost of the back contact solar cell is reduced, and a manufacturing process of the back contact solar cell is simplified.

In a possible embodiment, through a wet chemical process, the recess structures are formed on the interval regions and the second regions under the masking action of the second mask layer. In this case, a process temperature of the wet chemical process is greater than or equal to 61°C and less than or equal to 83°C; and/or, process time of the wet chemical process is greater than or equal to 60s and less than or equal to 450s; and/or, a wet chemical erosion solution used in the wet chemical process is an alkaline wet chemical erosion solution, and a volume ratio of an alkaline component to the alkaline wet chemical erosion solution is greater than or equal to 1% and less than or equal to 15%; and/or, a wet chemical erosion solution used in the wet chemical process contains a polishing additive, and a volume ratio of the polishing additive to the wet chemical erosion solution is greater than or equal to 0.5% and less than or equal to 3%.

Through the technical solution, the process temperature and the process time of the wet chemical process may influence a specification of the recess structures formed through the wet chemical process and a specification of the suspended end of the first doped semiconductor layer. Based on this, the process temperature of the wet chemical process is within the range, such that a small depth of the recess structure and a small suspension height and length of the suspended end of the first doped semiconductor layer due to a low process temperature can be prevented. In addition, a great depth of the recess structure due to a great process temperature can be prevented. The depth of the recess structure is equal to a depth by which the first interval sub-regions are concave toward the interior of the silicon substrate relative to the surface of the first region. Based on this, reference may be made to the above description for beneficial effects of preventing the small depth of the recess structure and the small suspension height and length of the suspended end of the first doped semiconductor layer and preventing the great depth of the recess structure. In addition, beneficial effects of the process time and the volume ratio of the alkaline component within the range are similar to those of enabling the process temperature to be greater than or equal to 61°C and less than or equal to 83°C, and will not be repeated herein. In addition, the volume ratio of the polishing additive to the wet chemical erosion solution is within the range, such that flatness of a recess bottom surface of the recess structures can be improved, and further the passivation effect of the surface passivation layer on the first interval sub-regions can be improved.

In a possible embodiment, under the masking action of the first mask layer, the surfaces of the second interval sub-regions are textured while the surfaces of the second interval sub-regions are concave toward the interior of the silicon substrate relative to the surface of the first interval sub-regions.

In a possible embodiment, a material of the second doped semiconductor layer includes silicon. In addition, the depositing a second doped semiconductor layer on the first doped semiconductor layer and in the recess structures, and forming a first mask layer on part of the second doped semiconductor layer on the second regions include: depositing a second intrinsic semiconductor layer on the first doped semiconductor layer and in the recess structures; then, conducting doping treatment on the second intrinsic semiconductor layer, forming the second doped semiconductor layer on the second intrinsic semiconductor layer, and forming a second doped silica glass layer integrally arranged on the second doped semiconductor layer; then, conducting heat treatment on part of the second doped silica glass layer on the first regions and the interval regions through a laser etching process, and forming the first mask layer on part (not subjected to the heat treatment) of the second doped silica glass layer on the second regions; and then, removing part, subjected to the heat treatment, of the second doped silica glass layer.

Through the technical solution, when the material of the second doped semiconductor layer includes silicon, a material of the second intrinsic semiconductor layer used to manufacture the second doped semiconductor layer includes silicon. Based on this, after doping treatment is conducted on the second intrinsic semiconductor layer, the second doped semiconductor layer can be obtained, and the second doped silica glass layer integrally arranged can be formed on the second doped semiconductor layer. Then, the heat treatment is conducted on part of the second doped silica glass layer on the first regions and the interval regions through the laser etching process. In this case, part, subjected to laser treatment, of the second doped silica glass layer has a lower density and is easy to remove. Part of the second doped silica glass layer on the second regions is not subjected to the laser treatment, and the part not subjected to the laser treatment has a higher density and is uneasy to remove. Thus, after the heat treatment, different parts of the second doped silica glass layer have different etching selection ratios, and the first mask layer for patterning the second doped semiconductor layer is obtained. It is unnecessary to additionally form other mask materials and other mask deposition procedures so as to obtain the first mask layer. In this way, manufacturing cost of the back contact solar cell is reduced, and a manufacturing process of the back contact solar cell is simplified.

In a possible embodiment, through the wet chemical process, part of the second doped semiconductor layer on the first regions and the interval regions is selectively removed under the masking action of the first mask layer, and the surface of the second interval sub-regions is concave toward the interior of the silicon substrate relative to the surface of the first interval sub-region. In this case, a process temperature of the wet chemical process is greater than or equal to 61°C and less than or equal to 83°C; and/or, process time of the wet chemical process is greater than or equal to 100s and less than or equal to 500s; and/or, a wet chemical erosion solution used in the wet chemical process is an alkaline wet chemical erosion solution, and a volume ratio of an alkaline component to the alkaline wet chemical erosion solution is greater than or equal to 1% and less than or equal to 3.5%; and/or, a wet chemical erosion solution used in the wet chemical process contains a texturing additive, and a volume ratio of the texturing additive to the wet chemical erosion solution is greater than or equal to 0.5% and less than or equal to 2%.

Through the technical solution, the process temperature and the process time of the wet chemical process may influence the depth by which the surfaces of the second interval sub-regions are concave toward the interior of the silicon substrate relative to the surfaces of the first interval sub-regions through the wet chemical process. Based on this, the process temperature of the wet chemical process is within the range, such that the small depth by which the surfaces of the second interval sub-regions are concave toward the interior of the silicon substrate relative to the surfaces of the first interval sub-regions due to the small process temperature can be prevented. In addition, the great depth by which the surfaces of the second interval sub-regions are concave toward the interior of the silicon substrate relative to the surfaces of the first interval sub-regions due to the great process temperature can be prevented. Reference may be made to the above description for beneficial effects of preventing the small and great depths by which the surfaces of the second interval sub-regions are concave toward the interior of the silicon substrate relative to the surfaces of the first interval sub-regions. In addition, beneficial effects of the process time and the volume ratio of the alkaline component within the range are similar to those of enabling the process temperature to be greater than or equal to 61°C and less than or equal to 83°C, and will not be repeated herein. In addition, the volume ratio of the texturing additive is within the range, such that a requirement of using a thick silicon substrate to manufacture the back contact solar cell due to a great volume ratio can be prevented, and thinning production is facilitated. An undesirable light trapping effect of the surfaces of the second interval sub-regions due to a small size of a textured structure formed on the surfaces of the second interval sub-regions because of the small volume ratio can be prevented, more light can be ensured to be refracted into the silicon substrate of via the surfaces of the second interval sub-regions, and further photoelectric conversion efficiency of the back contact solar cell can be improved.

In a possible embodiment, the manufacturing method for a back contact solar cell further includes: forming a first passivation layer, which includes the following step: forming the first passivation layer on the first regions and the first interval sub-regions after the providing a silicon substrate and before the forming a first doped semiconductor layer on the first regions and the first interval sub-region.

In a possible embodiment, the manufacturing method for a back contact solar cell further includes: forming a second passivation layer, which includes the following steps: depositing the second passivation layer on the first doped semiconductor layer and in recess structures after the forming the recess structures that are concave toward an interior of the silicon substrate on the interval regions and the second regions and before the depositing a second doped semiconductor layer on the first doped semiconductor layer and in the recess structures; and selectively removing part of the second passivation layer in the first regions and the interval regions under the masking action of the first mask layer after the selectively removing part of the second doped semiconductor layer on the first regions and the interval regions under a masking action of the first mask layer and before the causing the surface of the second interval sub-regions that are concave toward the interior of the silicon substrate relative to surfaces of the first interval sub-regions.

Reference may be made to analysis of beneficial effects of the first aspect and various implementations of the first aspect for beneficial effects of the second aspect and various implementations of the second aspect in the present application, which will not be repeated herein.

### BRIEF DESCRIPTION OF THE DRAWINGS

The accompanying drawings, used to provide further understanding of the present application, constitute part of the present application, and illustrative embodiments of the present application and their description serve to explain the present application and are not to be construed as unduly limiting the present application. In the accompanying drawings:
FIG. 1 is a scanning electron microscope (SEM) diagram of a longitudinal cutaway view of a structure of a back contact solar cell in the related art;
FIG. 2 is an SEM diagram of a longitudinal cutaway view of a structure of a back contact solar cell provided by an embodiment of the present application;
FIG. 3 is an SEM diagram of a longitudinal cutaway view of a structure of a back contact solar cell provided by an embodiment of the present application;
FIG. 4 is an SEM diagram of a longitudinal cutaway view of a structure of a back contact solar cell provided by an embodiment of the present application;
FIG. 5 is a schematic diagram of a longitudinal cutaway view of a structure of a back contact solar cell provided by an embodiment of the present application;
FIG. 6 is a schematic structural diagram of a back contact solar cell provided by an embodiment of the present application in a manufacturing process;
FIG. 7 is a schematic structural diagram of a back contact solar cell provided by an embodiment of the present application in a manufacturing process;
FIG. 8 is a schematic structural diagram of a back contact solar cell provided by an embodiment of the present application in a manufacturing process;
FIG. 9 is a schematic structural diagram of a back contact solar cell provided by an embodiment of the present application in a manufacturing process;
FIG. 10 is a schematic structural diagram of a back contact solar cell provided by an embodiment of the present application in a manufacturing process;
FIG. 11 is a schematic structural diagram of a back contact solar cell provided by an embodiment of the present application in a manufacturing process;
FIG. 12 is a schematic structural diagram of a back contact solar cell provided by an embodiment of the present application in a manufacturing process;
FIG. 13 is a schematic structural diagram of a back contact solar cell provided by an embodiment of the present application in a manufacturing process;
FIG. 14 is a schematic structural diagram of a back contact solar cell provided by an embodiment of the present application in a manufacturing process;
FIG. 15 is a schematic structural diagram of a back contact solar cell provided by an embodiment of the present application in a manufacturing process;
FIG. 16 is a schematic structural diagram of a back contact solar cell provided by an embodiment of the present application in a manufacturing process;
FIG. 17 is a schematic structural diagram of a back contact solar cell provided by an embodiment of the present application in a manufacturing process;
FIG. 18 is a schematic structural diagram of a back contact solar cell provided by an embodiment of the present application in a manufacturing process; and
FIG. 19 is a schematic structural diagram of a back contact solar cell provided by an embodiment of the present application in a manufacturing process.

Reference numerals: 11 silicon substrate, 12 first doped semiconductor layer, 13 second doped semiconductor layer, 14 first region, 15 second region, 16 interval region, 17 first interval sub-region, 18 second interval sub-region, 19 surface passivation layer, 20 first passivation layer, 21 second passivation layer, 22 recess structure, 23 first mask layer, 24 second mask layer, 25 first intrinsic semiconductor layer, 26 first doped silica glass layer, 27 second intrinsic semiconductor layer, and 28 second doped silica glass layer.

### DETAILED DESCRIPTION

Embodiments of the present application will be described below with reference to accompanying drawings. However, it should be noted that the description is merely illustrative, and is not intended to limit the scope of the present application. Further, description of well-known structures and technologies is omitted in the following description, such that concepts of the present application are prevented from being unnecessarily confused.

Various schematic structural diagrams according to the embodiments of the present application are shown in the drawings. The drawings are not drawn to scale, and some details are exaggerated and some details may be omitted for clear expression. Shapes of various regions and layers shown in the figures and their relative sizes and positional relationships are merely illustrative, and may actually be deviated due to manufacturing tolerances or technical limitations. Those skilled in the art may additionally design regions/layers having different shapes, sizes and relative positions according to actual needs.

In context of the present application, when a layer/element is described to be located "on" another layer/element, the layer/element may be directly located on another layer/element, or an intervening layer/element may exist between the two layers/elements. In addition, when a layer/element is located "on" another layer/element in a direction, the layer/element may be located "under" another layer/element when the direction is reversed. To make to-be-solved technical problems, technical solutions and beneficial effects of the present application clearer, the present application will be described in further detail below in conjunction with the accompanying drawings and the embodiments. It should be understood that specific embodiments described herein are merely illustrative of the present application and are not intended to limit the present application.

In addition, the terms "first" and "second" are merely for descriptive purposes and are not to be construed as indicating or implying their relative importance or implicitly specifying a number of indicated technical features. Thus, features limited by "first" and "second" may explicitly or implicitly include one or more of the features. In the description of the present application, "plurality" means two or more, unless expressly specified otherwise. "A plurality of" means one or more, unless expressly specified otherwise.

In the description of the present application, it should be noted that, unless expressly specified otherwise, the terms such as "mount", "connect" and "connection" are to be construed broadly. For example, they can denote fixed connection, detachable connection, or integral connection; mechanical connection or electrical connection; and direct connection or indirect connection through an intermediary medium, or communication between interiors of two elements or an interworking relationship between two elements. For those of ordinary skill in the art, specific meanings of the terms in the present application may be understood according to specific circumstances.

At present, solar cells are increasingly widely used as a new alternative energy solution. A photovoltaic solar cell is a device converting solar energy into electric energy. Specifically, the solar cell generates carriers through a photovoltaic principle, and then the carriers are exported through electrodes, such that the electric energy can be efficiently used.

When positive and negative electrodes included in the solar cell are located on a back surface of the solar cell, the solar cell is a back contact solar cell. A light receiving surface of the back contact solar cell is not shielded by a metal electrode. Thus, the back contact solar cell has higher short-circuit current and photoelectric conversion efficiency than a solar cell with a light receiving surface shielded, and is one of the technical directions to implement high-efficiency crystalline silicon cells at present. In addition, a surface passivation layer is formed on a back surface of a semiconductor substrate included in the back contact solar cell, such that the carrier recombination rate on the back surface of the semiconductor substrate can be reduced, and working performance of the back contact solar cell can be improved.

Specifically, a conventional back contact solar cell generally includes a silicon substrate, a first doped semiconductor layer, a second doped semiconductor layer, and a surface passivation layer. The first doped semiconductor layer and the second doped semiconductor layer are alternately distributed at intervals on a back surface of the silicon substrate in a direction parallel to the silicon substrate. The surface passivation layer covers the first doped semiconductor layer, the second doped semiconductor layer, and part of the back surface between the first doped semiconductor layer and the second doped semiconductor layer, so as to conduct passivation on back surfaces of the first doped semiconductor layer and the second doped semiconductor layer and the part of the back surface of the silicon substrate between the first doped semiconductor layer and the second doped semiconductor layer, such that the carrier recombination rate is reduced.

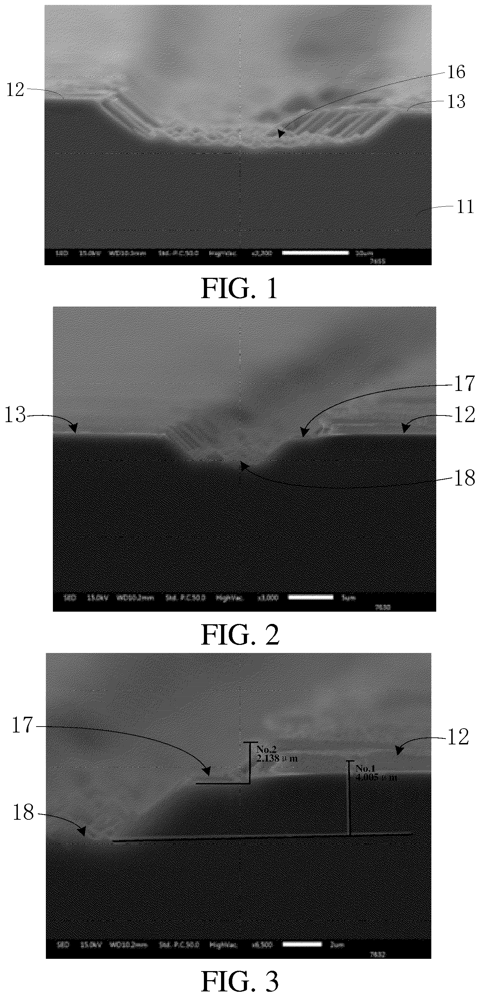

However, as shown in FIG. 1, in the conventional back contact solar cell, a surface of a region of the back surface of the silicon substrate 11 between the first doped semiconductor layer 12 and the second doped semiconductor layer 13 is a textured surface. Compared with a flat surface, the textured surface has a larger specific surface area. Within a particular range, a forming thickness of the surface passivation layer is inversely proportional to a specific surface area of a surface of a corresponding region located below the surface passivation layer. Meanwhile, the passivation effect of the surface passivation layer is proportional to a thickness of the surface passivation layer. Thus, when the surface of the region of the back surface of the silicon substrate 11 between the first doped semiconductor layer 12 and the second doped semiconductor layer 13 is a textured surface, a thickness of the surface passivation layer formed on this surface is relatively small. Consequently, the passivation effect of the silicon substrate 11 on the back surface is poor, and is not conducive to improvement in photoelectric conversion efficiency of the back contact solar cell.

To solve the technical problems, according to a first aspect, an embodiment of the present application provides a back contact solar cell. As shown in FIG. 2 to FIG. 5, the back contact solar cell includes: a silicon substrate 11, a first doped semiconductor layer 12, a second doped semiconductor layer 13, and a surface passivation layer 19. The first doped semiconductor layer 12 and the second doped semiconductor layer 13 are alternately distributed at intervals on a back surface of the silicon substrate 11 in a direction parallel to the silicon substrate 11. A conduction type of the first doped semiconductor layer 12 is opposite to that of the second doped semiconductor layer 13. On the back surface of the silicon substrate 11, regions corresponding to the first doped semiconductor layer 12 are first regions 14, regions corresponding to the second doped semiconductor layer 13 are second regions 15, and regions between the first regions 14 and the adjacent second regions 15 are interval regions 16. In an arrangement direction of the first regions 14 and the second regions 15, the interval regions 16 adjacent to the first doped semiconductor layer 12 are first interval sub-regions 17, and the other interval regions are second interval sub-regions 18. Surfaces of the first interval sub-regions 17 and surfaces of the second regions 15 are concave toward an interior of the silicon substrate 11 relative to surfaces of the first regions 14, and surfaces of the second interval sub-regions 18 are concave toward an interior of the silicon substrate 11 relative to the surfaces of the first interval sub-regions 17. The first interval sub-regions 17 have flat surfaces. The surface passivation layer 19 covers the first doped semiconductor layer 12, the second doped semiconductor layer 13, and the interval regions 16.

It should be noted that, the first interval sub-regions have the flat surfaces that are flat surfaces in a broad sense relative to a textured surface. As shown in FIG. 2 and FIG. 3, the surfaces of the first interval sub-regions 17 may be bumpy, or absolutely flat on the premise of ensuring that the surfaces of the first interval sub-regions 17 are more flat than the textured surface. In addition, the first interval sub-regions 17 and the second interval sub-regions 18 may conduct transition in a manner such as a right angle or an obtuse angle, or may conduct transition in a manner of relative rounding. In an actual application process, regions corresponding to the first interval sub-regions 17 in the silicon substrate may be considered as a platform structure adjacent to the second interval sub-region. It may be understood that the flat surface has a smaller specific surface area than the textured surface, and a thickness of the surface passivation layer formed on the first interval sub-regions 17 having the flat surfaces may be greater than that of the surface passivation layer formed on the textured surface. In this case, compared with the surface passivation layer formed on the textured surface, the surface passivation layer formed on the first interval sub-regions 17 having the flat surfaces have a higher surface passivation effect and fewer recombination centers. Thus, the carrier recombination rate on the first interval sub-regions 17 is further reduced, and the photoelectric conversion efficiency of the back contact solar cell is further improved.

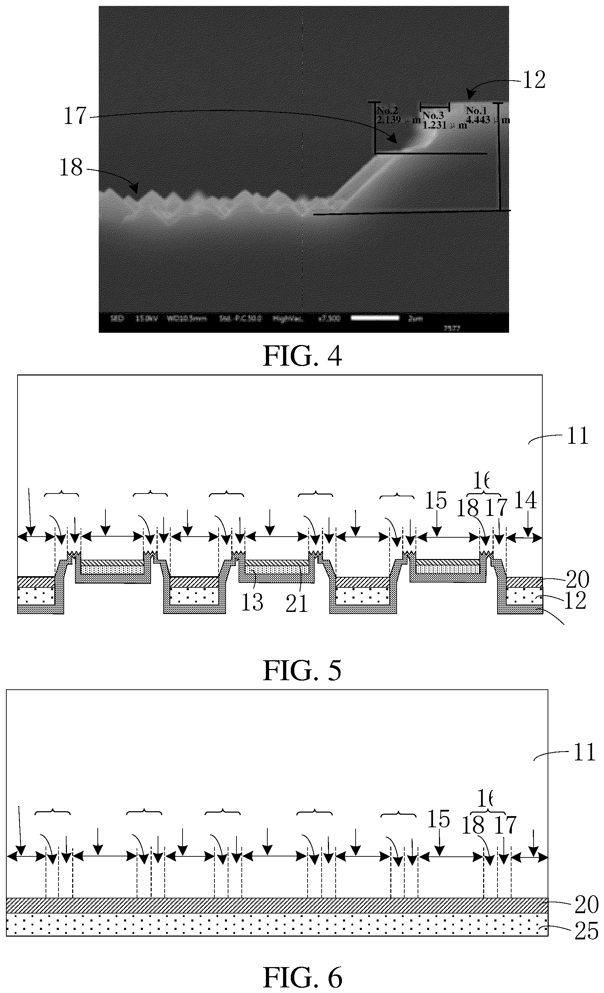

Through the technical solution, as shown in FIG. 5, in the back contact solar cell provided by the embodiment of the present application, the first doped semiconductor layer 12 and the second doped semiconductor layer 13 having opposite conduction types are alternately distributed at intervals on the back surface of the silicon substrate 11 in the direction parallel to the silicon substrate 11. Based on this, the interval regions 16 on the back surface of the silicon substrate 11 may separate the first doped semiconductor layer 12 from the second doped semiconductor layer 13, such that the carrier recombination rate at a lateral interface of the first doped semiconductor layer 12 and the second doped semiconductor layer 13 is reduced, and photoelectric conversion efficiency of the back contact solar cell is improved. In addition, as shown in FIG. 2 to FIG. 5, on the interval regions 16, part adjacent to the first doped semiconductor layer 12 is the first interval sub-regions 17, and the other regions are the second interval sub-regions 18. In addition, the surfaces of the first interval sub-regions 17 and the surfaces of the second regions 15 are concave toward the interior of the silicon substrate 11 relative to the surfaces of the first regions 14. In this case, the first doped semiconductor layer 12 is formed on the first regions 14 of the back surface, and the second doped semiconductor layer 13 is formed on the second regions 15 of the back surface. Thus, when the surfaces of the second regions 15 are concave toward the interior of the silicon substrate 11 relative to the surfaces of the first regions 14, the first doped semiconductor layer 12 and the second doped semiconductor layer 13 that are located on the back surface of the silicon substrate 11 and have the opposite conduction types are at least partially staggered in a thickness direction of the silicon substrate 11. Further, a risk of electric leakage on the back surface is reduced, and electrical reliability of the back contact solar cell is improved. In addition, as shown in FIG. 5, the back contact solar cell provided by an embodiment of the present application further includes the surface passivation layer 19 covering the first doped semiconductor layer 12, the second doped semiconductor layer 13, and the interval regions 16, such that chemical passivation is conducted on the back surface of the first doped semiconductor layer 12 and the second doped semiconductor layer 13 and the interval regions 16, and the carrier recombination rate is reduced. Based on this, the first interval sub-regions 17 have flat surfaces. Compared with the textured surface, the flat surface has a smaller specific surface area. However, within a particular range, a thickness of the surface passivation layer 19 is inversely proportional to a specific surface area of a surface located under the surface passivation layer, and the passivation effect of the surface passivation layer 19 is proportional to the thickness of the surface passivation layer. Thus, a thickness of the surface passivation layer 19 formed on the first interval sub-regions 17 is greater than a thickness of the surface passivation layer formed on the textured surface, and accordingly, the passivation effect of the surface passivation layer 19 on the first interval sub-regions 17 is greater than that of the surface passivation layer on the textured surface. In this case, compared with a conventional back contact solar cell in which surfaces of all parts of interval regions are textured surfaces, in the back contact solar cell provided by an embodiment of the present application, at least the first interval sub-regions 17 included in the interval regions 16 have flat surfaces. In this case, the surface passivation layer 19 has a higher surface passivation effect on the first interval sub-regions 17, the carrier recombination rate on the first interval sub-regions 17 is further reduced, and the photoelectric conversion efficiency of the back contact solar cell is further improved.

In an actual application process, as shown in FIG. 5, the light receiving surface of the silicon substrate 11 may be a flat surface. Alternatively, the light receiving surface of the silicon substrate may be the textured surface. The textured surface has a light trapping effect. Thus, when the light receiving surface of the silicon substrate is the textured surface, reflectivity of the light receiving surface can be reduced, more light may be refracted from the light receiving surface into the silicon substrate and be absorbed and used by the silicon substrate, and the photoelectric conversion efficiency of the back contact solar cell is improved.

In addition, in terms of ranges, boundaries of the first regions, the second regions and the interval regions on the back surface of the silicon substrate and boundaries of the first interval sub-regions and the second interval sub-regions in the interval regions are virtual boundaries. As shown in FIG. 5, the first doped semiconductor layer 12 is formed on the first regions 14. Thus, a range of the first regions 14 on the back surface of the silicon substrate 11 may be determined according to a requirement for a forming range of the first doped semiconductor layer 12 in an actual application scene. Further, the second doped semiconductor layer 13 is formed on the second regions 15. Thus, a range of the second regions 15 on the back surface of the silicon substrate 11 may be determined according to a requirement for a forming range of the second doped semiconductor layer 13 in an actual application scene. Regarding the interval regions 16, as described above, the interval regions 16 may separate the first doped semiconductor layer 12 and the second doped semiconductor layer 13 having the opposite conduction types, so as to suppress electric leakage. Thus, a range of the interval regions 16 on the back surface may be determined according to a requirement for an anti-leakage distance between the first doped semiconductor layer 12 and the second doped semiconductor layer 13 in an actual application scene.

For example, in the arrangement direction of the first regions and the second regions, a length of the interval region may be greater than or equal to 20 µm and less than or equal to 110 µm. For example, the length of the interval region may be 20 µm, 40 µm, 60 µm, 80 µm, 100 µm, 110 µm, etc. In this case, the length of the interval region is within the range, such that electric leakage between the first doped semiconductor layer and the second doped semiconductor layer due to a small distance can be prevented, and high electrical reliability of the back contact solar cell can be ensured. In addition, the situation that carriers on the back surface fail to be collected by the first doped semiconductor layer and/or the second doped semiconductor layer in time and exported by corresponding electrodes due to a small forming range of the first doped semiconductor layer and/or the second doped semiconductor layer on the back surface because of a great distance can be prevented, and further the carrier recombination rate on the back surface can be reduced.

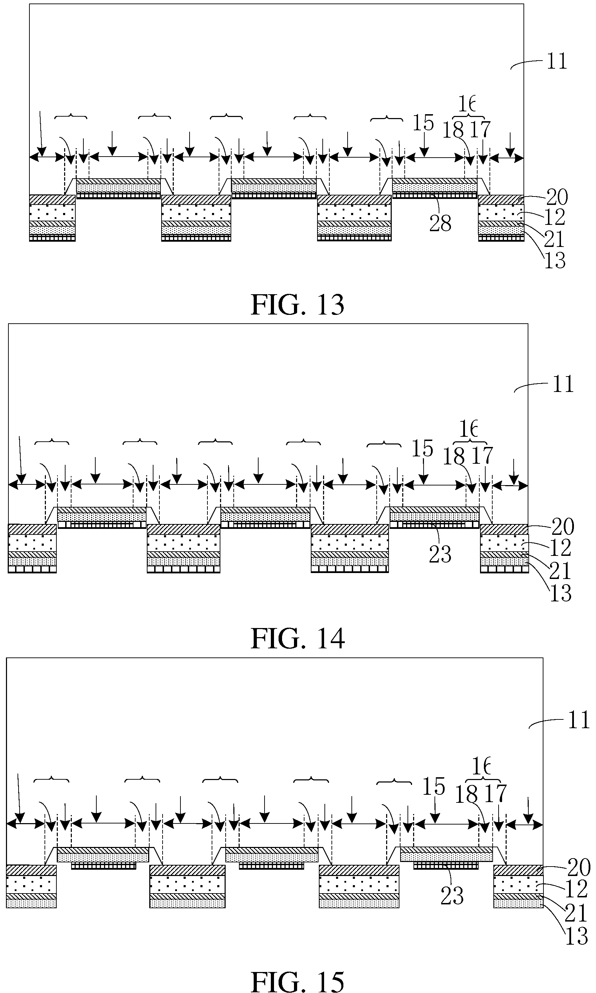

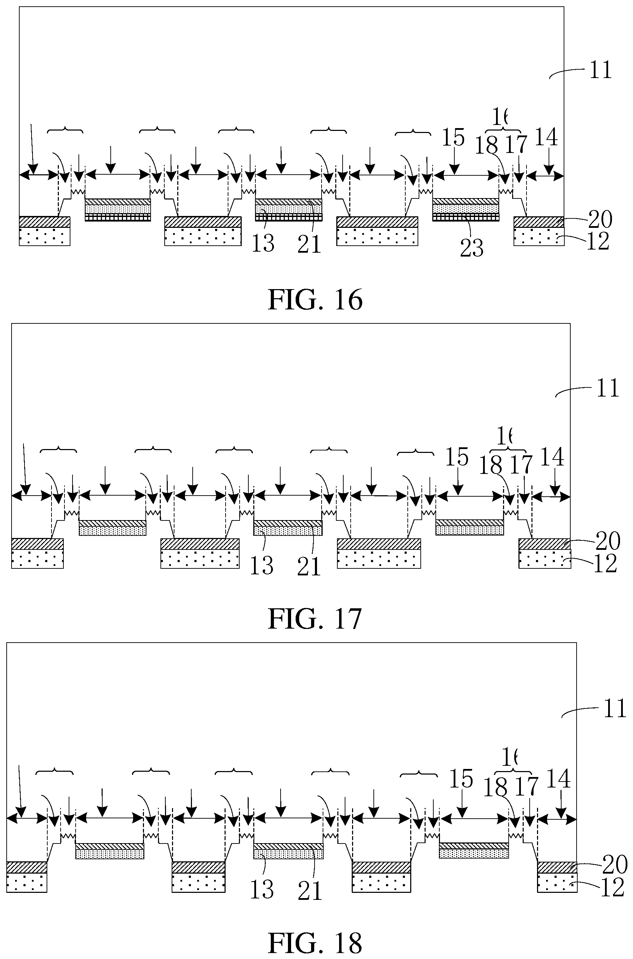

For the first interval sub-regions and the second interval sub-regions included in the interval regions, as shown in FIG. 15 and FIG. 16, the surfaces of the first interval sub-regions 17 may be flat surfaces. As shown in FIG. 15, the surfaces of the second interval sub-regions may be flat surfaces. Alternatively, as shown in FIG. 16, the surfaces of the second interval sub-regions may be the textured surfaces. It may be understood that the first interval sub-regions 17 has the flat surfaces due to a suspended end, at least located above the first interval sub-regions 17, of the first doped semiconductor layer 12 in a manufacturing process (as shown in FIG. 18, the suspended end may be removed before the surface passivation layer is formed). Under a protection effect of the suspended end, a corresponding erosion solution conducts erosion on only the second interval sub-regions 18, and a phenomenon of a bumpy surface caused by excessive etching or other factors due to influence of the erosion solution on the surface of the first interval sub-regions 17 can be avoided. Thus, the first interval sub-regions 17 having the flat surfaces are formed. Based on this, ranges of the first interval sub-regions 17 and the second interval sub-regions 18 may be determined according to a length of the suspended end of the first doped semiconductor layer 12 in an actual manufacturing process and an actual requirement, and are not specifically limited herein.

For example, in the arrangement direction of the first regions and the second regions, a length of the first interval sub-region may be greater than or equal to 1000 nm and less than or equal to 3000 nm. For example, the length of the first interval sub-region may be 1000 nm, 1300 nm, 1600 nm, 1900 nm, 2000 nm, 2300 nm, 2600 nm, 2900 nm, 3000 nm, etc. In this case, the length of the first interval sub-region is within the range, such that insignificant improvement in the passivation effect of the surface passivation layer on the interval regions due to a small length of the first interval sub-region can be prevented, and a low carrier recombination rate on the back surface can be ensured. In addition, greater manufacturing difficulty caused by a requirement of forming the suspended end having a greater length in a manufacturing process due to a greater length of the first interval sub-region can be prevented, and manufacturing difficulty of the back contact solar cell can be reduced.

In terms of concave depths, the depths of the first interval sub-regions, the second interval sub-regions and the second regions on the back surface that are concave toward the interior of the silicon substrate may be determined according to the actual application scene, as long as it is ensured that the surface of the first interval sub-regions and the surface of the second regions are concave toward the interior of the silicon substrate relative to the surfaces of the first regions and the surfaces of the second interval sub-regions are concave toward the interior of the silicon substrate relative to the surface of the first interval sub-regions.

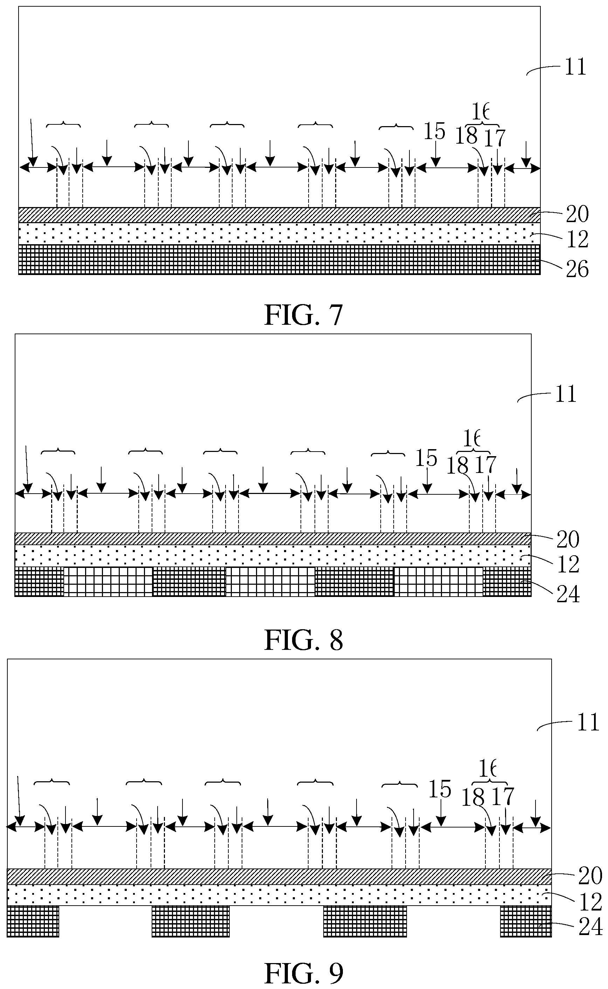

Specifically, the surfaces of the first interval sub-regions and the second regions may be staggered in the thickness direction of the silicon substrate. Alternatively, as shown in FIG. 5, the surfaces of the first interval sub-regions 17 may be flush with the surfaces of the second regions 15. In this case, in an actual manufacturing process, as shown in FIG. 9 to FIG. 11, after the first doped semiconductor layer 12 integrally arranged is formed on the back surface, the first doped semiconductor layer 12 needs to be selectively etched. After selective etching, the surfaces of the interval regions 16 and the second regions 15 are concave inward relative to the surfaces of the first regions 14 with an identical concave depth. Based on this, when the surface of the first interval sub-regions 17 is flush with the surface of the second regions 15, that is, when depths by which the surfaces of the first interval sub-regions 17 and the second regions 15 are concave toward the interior of the silicon substrate 11 are identical, it is unnecessary to conduct selective etching on the first interval sub-regions 17 or the second regions 15 after conducting selective etching on the first doped semiconductor layer 12. In this way, a selected material thickness of the silicon substrate 11 can further be reduced while a manufacturing process of the back contact solar cell can be simplified, and thinning production can be facilitated.

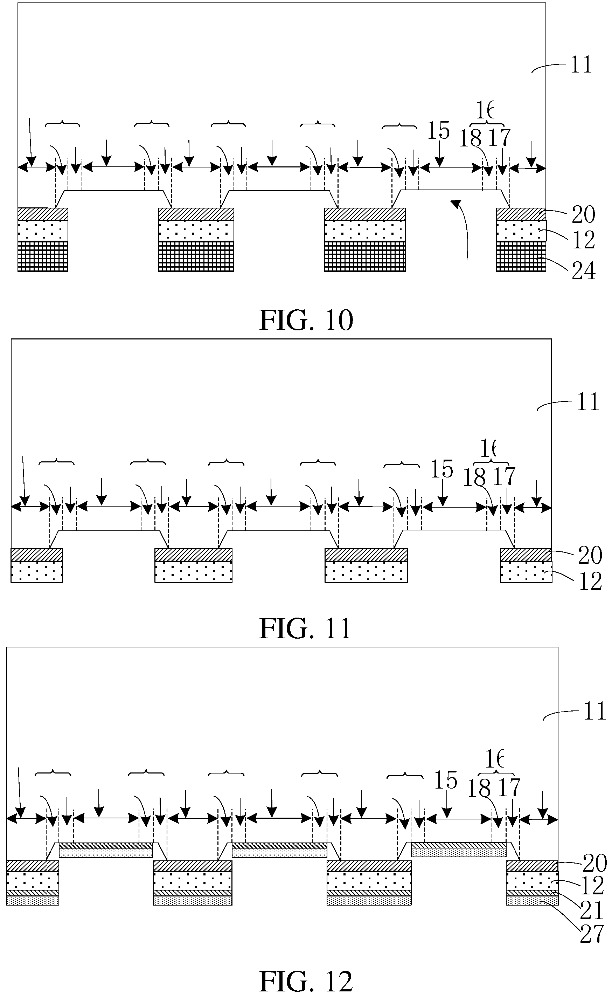

For example, a specific depth by which the surfaces of the first interval sub-regions are concave toward the interior of the silicon substrate may be greater than or equal to 500 nm and less than or equal to 2500 nm relative to the surface of the first region. For example, the depth by which the surfaces of the first interval sub-regions are concave toward the interior of the silicon substrate may be 500 nm, 1000 nm, 1500 nm, 2000 nm, 2500 nm, etc. In this case, the depth by which the surfaces of the first interval sub-regions are concave toward the interior of the silicon substrate is within the range, such that a small staggering degree between the first doped semiconductor layer and the second doped semiconductor layer that are located on the back surface of the silicon substrate and have the opposite conduction types in the thickness direction of the silicon substrate due to a small thickness can be prevented, and further the risk of electric leakage on the back surface can be reduced. In addition, in an actual manufacturing process, as shown in FIG. 10 and FIG. 11, the recess structures 22 that are concave toward the interior of the silicon substrate 11 relative to the surface of the first regions 14 are formed on the interval regions 16 and the second regions 15 on the back surface of the silicon substrate 11, such that the ends of the first doped semiconductor layer 12 adjacent to the interval regions 16 are suspended, and the depth by which the surfaces of the first interval sub-regions 17 are concave toward the interior of the silicon substrate 11 is identical to that of the recess structures 22. Based on this, the depth by which the surfaces of the first interval sub-regions 17 are concave toward the interior of the silicon substrate 11 is within the range, such that a smaller length of the end suspended on the interval region 16 (further a smaller length of the first interval sub-region 17) due to influence of an etching solution etching the silicon substrate 11 on the suspended end of the first doped semiconductor layer 12 because of a great depth by which the surfaces of the first interval sub-regions 17 are concave toward the interior of the silicon substrate 11 can be prevented, and a higher passivation effect of the surface passivation layer 19 on the interval regions 16 can be ensured. Further, a requirement of using a thick silicon substrate 11 due to a great depth by which the surfaces of the first interval sub-regions 17 are concave toward the interior of the silicon substrate 11 can be prevented. Thus, thinning production of the back contact solar cell can be facilitated while manufacturing cost of the back contact solar cell can be reduced.

For example, the depth by which the surfaces of the second interval sub-regions are concave toward the interior of the silicon substrate is greater than or equal to 3 µm and less than or equal to 5 µm relative to the surface of the first region. For example, a depth by which the surfaces of the second interval sub-regions are concave toward the interior of the silicon substrate may be greater than or equal to 3 µm and less than or equal to 5 µm relative to the surface of the first regions. In this case, in an actual manufacturing process, after the first doped semiconductor layer is formed and the recess structures are formed in the second regions and the interval regions, the second doped semiconductor layer may be deposited on the back surface, and the second doped semiconductor layer may be selectively etched. To prevent electric leakage, generally, after part of the second doped semiconductor layer on the second interval sub-regions is removed, downward etching may continue to be conducted for a specific depth, such that the part of the second doped semiconductor layer on the second interval sub-regions can be ensured to be completely removed. Based on this, the depth by which the surfaces of the second interval sub-regions are concave toward the interior of the silicon substrate is within the range, such that a high risk of electric leakage between the first doped semiconductor layer and the second doped semiconductor layer having the opposite conduction types due to the small depth can be prevented, and high electrical reliability of the back contact solar cell can be ensured. In addition, it may be understood that, the greater depth by which the surfaces of the second interval sub-regions are concave toward the interior of the silicon substrate corresponds to longer erosion time of the erosion solution and greater influence of the erosion solution on another structure. Based on this, the depth by which the surfaces of the second interval sub-regions are concave toward the interior of the silicon substrate is within the range, such that a smaller length of the suspended end of the first doped semiconductor layer and the first interval sub-region due to influence of the erosion solution because of the great depth can be prevented, and a higher passivation effect of the surface passivation layer on the interval regions can be ensured. Further, a requirement of using a thick silicon substrate due to a great depth by which the surfaces of the second interval sub-regions are concave toward the interior of the silicon substrate can be prevented. Thus, thinning production of the back contact solar cell can be facilitated while manufacturing cost of the back contact solar cell can be reduced.

In terms of shapes, as described above, the surfaces of the first interval sub-regions may be the flat surfaces. The surfaces of the second interval sub-regions may be the flat surfaces or the textured surfaces. As described above, compared with the interval regions in the conventional back contact solar cell as the textured surface, the flat surface has a smaller specific surface area, and a thick surface passivation layer has a higher surface passivation effect and fewer recombination centers. Thus, the carrier recombination rate on the interval regions having the flat surfaces is further reduced, and the photoelectric conversion efficiency of the back contact solar cell is further improved. It should be noted that, when the surfaces of the second interval sub-regions are the textured surfaces, the depth by which the surfaces of the second interval sub-regions are concave toward the interior of the silicon substrate refers to: a depth of a middle portion having a textured structure on the surface of the second interval sub-regions that are concave toward the interior of the silicon substrate relative to the surfaces of the first regions in the thickness direction of the silicon substrate.

For a side wall shape of the interval regions, a surface of each part of a side wall of the interval regions adjacent to the first doped semiconductor layer may be arranged perpendicular to a horizontal plane. Alternatively, as shown in FIG. 2 to FIG. 5, a surface of at least part of the side wall of the interval region 16 adjacent to the first doped semiconductor layer 12 is arranged obliquely relative to the horizontal plane, and a cross-sectional area of at least part of the interval region 16 gradually increases in a direction from a light receiving surface to the back surface. In this case, a cross-sectional area of one side of the interval regions 16 close to the light receiving surface is smaller than that of one side of the interval regions close to the back surface, such that a distance between the first doped semiconductor layer 12 and the second doped semiconductor layer 13 having the opposite conduction types is increased. Thus, a risk of electric leakage on the back surface of the back contact solar cell is reduced, and high electrical reliability of the back contact solar cell is ensured. In addition, the part, arranged obliquely relative to the horizontal plane, of the side walls of the interval regions 16 adjacent to the first doped semiconductor layer 12 is conducive to light reflection. Thus, more light enters the silicon substrate 11 from the back surface of the back contact solar cell under a reflection effect of the part, arranged obliquely relative to the horizontal plane, of the side walls of the interval regions 16 adjacent to the first doped semiconductor layer 12, and further the photoelectric conversion efficiency of the back contact solar cell is improved.

In this case, an included angle between the part, arranged obliquely relative to the horizontal plane, of the side walls of the interval regions adjacent to the first doped semiconductor layer and the horizontal plane may be determined according to an actual manufacturing process and a light reflection requirement on side walls of the recess structures, and is not specifically limited herein.

For example, the included angle between the part, arranged obliquely relative to the horizontal plane, of the side walls of the interval regions adjacent to the first doped semiconductor layer and the horizontal plane may be greater than or equal to 52° and less than or equal to 58°. For example, the included angle between the part, arranged obliquely relative to the horizontal plane, of the side walls of the interval regions adjacent to the first doped semiconductor layer and the horizontal plane may be 52°, 53°, 54°, 55°, 56°, 57°, 58°, etc. In this case, the included angle is within the range, such that more light can be ensured to enter the silicon substrate and be used by the silicon substrate under a great reflection effect of the part, arranged obliquely relative to the horizontal plane, of the side walls of the interval regions adjacent to the first doped semiconductor layer, and further a light utilization rate of the back contact solar cell can be improved.

In addition, in this case, as shown in FIG. 2, FIG. 3 and FIG. 5, the surface of each part of the side wall of the interval regions 16 adjacent to the first doped semiconductor layer 12 may be arranged obliquely relative to the horizontal plane. Alternatively, as shown in FIG. 4, in the side wall of the interval regions 16 adjacent to the first doped semiconductor layer 12, only the surface of part of the side wall is arranged obliquely relative to the horizontal plane, and the surface of the part of the side wall close to the back surface is arranged perpendicular to the horizontal plane. In this case, in the back contact solar cell provided by the embodiment of the present application, a shape of part of the interval regions 16 adjacent to the first doped semiconductor layer 12 provides another possible embodiment, such that applicability of the back contact solar cell provided by the embodiment of the present application in different application scenes is improved.

A height of the surface arranged perpendicular to the horizontal plane may be determined according to an actual manufacturing process, and is not specifically limited herein.

For a shape of side walls of the interval regions adjacent to the second doped semiconductor layer, a surface of each part of the side wall of the interval regions adjacent to the second doped semiconductor layer may be arranged perpendicular to the horizontal plane. Alternatively, as shown in FIG. 2, the side walls of the interval regions 16 adjacent to the second doped semiconductor layer 13 may be arranged obliquely relative to the horizontal plane.

For the first doped semiconductor layer, in terms of materials, a material of the first doped semiconductor layer may be a semiconductor material such as silicon, germanium-silicon, germanium, or gallium arsenide. In terms of arrangement forms of substances, a crystalline phase of the first doped semiconductor layer may be amorphous, microcrystalline, nanocrystalline, monocrystalline, or polycrystalline. In terms of conduction types, the conduction type of the first doped semiconductor layer may be opposite or identical to that of the silicon substrate. A thickness of the first doped semiconductor layer may be set according to actual needs, and is not specifically limited herein. For example, the thickness of the first doped semiconductor layer may be greater than or equal to 100 nm and less than or equal to 500 nm.

In an actual application process, the first doped semiconductor layer may be directly formed on the first regions of the silicon substrate. Alternatively, as shown in FIG. 5, the back contact solar cell further includes first passivation layer 20 located between the first regions 14 of the silicon substrate 11 and the first doped semiconductor layer 12. In this case, the first passivation layer 20 and the first doped semiconductor layer 12 may constitute selective contact structures, such that chemical passivation and selective collection are conducted on the first regions 14 included in the back surface of the silicon substrate 11 and the carriers having the corresponding conduction type respectively, the carrier recombination rate on the back surface is reduced, and the photoelectric conversion efficiency of the back contact solar cell is improved.

Specifically, a material of the first passivation layer may be determined according to the material of the first doped semiconductor layer and a type of the selective contact structure constituted by the first passivation layer and the first doped semiconductor layer in an actual application scene, and is not specifically limited herein.

For example, when the selective contact structure constituted by the first passivation layer and the first doped semiconductor layer is a tunneling passivation contact structure, the first doped semiconductor layer is a doped polycrystalline silicon layer, and the first passivation layer is a tunneling passivation layer. A material of the tunneling passivation layer may include silicon oxide, aluminum oxide, titanium oxide, or other materials.

For example, when the selective contact structures constituted by the first passivation layer and the first doped semiconductor layer are heterogeneous contact structures, the first doped semiconductor layer is a doped amorphous silicon layer and/or a doped microcrystalline silicon layer, and the first passivation layer is an intrinsic amorphous silicon layer and/or an intrinsic microcrystalline silicon layer.

A thickness of the first passivation layer may be set according to actual needs, and is not specifically limited herein. For example, the thickness of the first passivation layer may be greater than or equal to 0.5 nm and less than or equal to 3 nm.

For the second doped semiconductor layer, reference may be made to the material, the thickness, and the like of the first doped semiconductor layer for a material, a thickness, and the like of the second doped semiconductor layer, which will not be repeated herein.

Alternatively, in an actual application process, the second doped semiconductor layer may be directly formed on the second regions of the silicon substrate. Alternatively, as shown in FIG. 5, the back contact solar cell further includes a second passivation layer 21 located between the second regions 15 of the silicon substrate 11 and the second doped semiconductor layer 13. In this case, the second passivation layer 21 and the second doped semiconductor layer 13 may constitute selective contact structures, such that chemical passivation and selective collection are conducted on the second regions 15 included in the back surface of the silicon substrate 11 and the carriers having the corresponding conduction type respectively, the carrier recombination rate on the back surface is reduced, and the photoelectric conversion efficiency of the back contact solar cell is improved.

Specifically, a material of the second passivation layer may be determined according to the material of the second doped semiconductor layer and a type of the selective contact structures constituted by the second passivation layer and the second doped semiconductor layer in an actual application scene, and is not specifically limited herein.

For example, when the selective contact structure constituted by the second passivation layer and the second doped semiconductor layer is a tunneling passivation contact structure, the second doped semiconductor layer is a doped polycrystalline silicon layer, and the second passivation layer is a tunneling passivation layer. A material of the tunneling passivation layer may include silicon oxide, aluminum oxide, titanium oxide, or other materials.

For example, when the selective contact structure constituted by the second passivation layer and the second doped semiconductor layer is a heterogeneous contact structure, the second doped semiconductor layer is a doped amorphous silicon layer and/or a doped microcrystalline silicon layer, and the second passivation layer is an intrinsic amorphous silicon layer and/or an intrinsic microcrystalline silicon layer.

For the surface passivation layer, a material of the surface passivation layer may be any insulation material having a passivation function, such as silicon oxide, aluminum oxide, or silicon nitride. The thickness of the surface passivation layer may be determined according to an actual application scene, and is not specifically limited herein.

According to a second aspect, an embodiment of the present application provides a manufacturing method for a back contact solar cell. A manufacturing process will be described below according to cutaway views of operation shown in FIG. 6 to FIG. 19. Specifically, the manufacturing method for a back contact solar cell included the following steps:
Firstly, a silicon substrate is provided. First regions and second regions alternately distributed at intervals and interval regions located between the first regions and the adjacent second regions are provided on a back surface of the silicon substrate in a direction parallel to the silicon substrate. In an arrangement direction of the first regions and the second regions, the interval regions adjacent to the first regions are first interval sub-regions, and the other interval regions are second interval sub-regions.

Specifically, reference may be made to the above description for ranges of the first regions, the second regions, and the first interval sub-regions and the second interval sub-regions included in the interval regions on the back surface, which will not be repeated herein.

Then, as shown in FIG. 11, a first doped semiconductor layer 12 is formed on the first regions 14 and the first interval sub-regions 17. Recess structures 22 that are concave toward an interior of the silicon substrate 11 are formed on the interval regions 16 and the second regions 15, and an end of the first doped semiconductor layer 12 adjacent to the interval regions 16 is suspended. Recess bottoms of the recess structures 22 are flat surfaces.

In an actual manufacturing process, as shown in FIG. 9, after the silicon substrate 11 is provided, the first doped semiconductor layer 12 integrally arranged may be formed on the back surface of the silicon substrate 11, and a second mask layer 24 may be arranged on part of the first doped semiconductor layer 12 on the first regions 14 and the first interval sub-regions 17. Then, as shown in FIG. 10, part of the first doped semiconductor layer 12 on the second interval sub-regions 18 and the second regions 15 is selectively removed under a masking action of the second mask layer 24, such that a suspended end of the first doped semiconductor layer 12 relative to the first interval sub-regions 17 may be obtained. Then, as shown in FIG. 11, the recess structures 22 are formed on the interval regions 16 and the second regions 15 under the masking action of the second mask layer 24.

Reference may be made to the above description for a material and a thickness of the first doped semiconductor layer. For the second mask layer, a material of the second mask layer may be any material having a masking function, and is not specifically limited herein. Further, a formation process and a specific formation procedure of a doped semiconductor layer and the second mask layer may be determined according to specific materials of the first doped semiconductor layer and the second mask layer.

For example, when the material of the first doped semiconductor layer includes silicon, the steps that the first doped semiconductor layer integrally arranged is formed on the back surface of the silicon substrate, and the second mask layer are arranged on the part of the first doped semiconductor layer on the first regions and the first interval sub-regions may include the following steps: As shown in FIG. 6, a first intrinsic semiconductor layer 25 integrally arranged is formed on the back surface of the silicon substrate 11. Then, as shown in FIG. 7, doping treatment is conducted on the first intrinsic semiconductor layer 25, the first doped semiconductor layer 12 are formed on the first intrinsic semiconductor layer, and a first doped silica glass layer 26 integrally arranged is formed on the first doped semiconductor layer 12. Then, as shown in FIG. 8, heat treatment is conducted on part of the first doped silica glass layer on the second interval sub-regions 18 and the second regions 15 through a laser etching process, and the second mask layer 24 is formed on part (that is, part on the first regions and the first interval sub-regions), not subjected to the heat treatment, of the first doped silica glass layer. Then, as shown in FIG. 9, part, subjected to the heat treatment, of the first doped silica glass layer is removed.

Specifically, the case that the material of the first doped semiconductor layer includes silicon may indicate that the material of the first doped semiconductor layer only includes silicon; or the material of the first doped semiconductor layer includes silicon and other semiconductor materials such as germanium-silicon. Further, in an actual manufacturing process, the first intrinsic semiconductor layer integrally arranged on the back surface may be formed through processes such as chemical vapor deposition. Then, doping treatment may be conducted on the first intrinsic semiconductor layer through processes such as diffusion. After the doping treatment, the first doped semiconductor layer can be obtained, and the first doped silica glass layer integrally arranged can be formed on the first doped semiconductor layer. Then, heat treatment is conducted on part of the first doped silica glass layer through the laser etching process. In this case, as shown in FIG. 8, part, subjected to laser treatment, of the first doped silica glass layer has a lower density and is easy to remove. Part, not subjected to laser treatment, of the first doped silica glass layer has a higher density and is uneasy to remove. Thus, after the heat treatment, different parts of the first doped silica glass layer have different etching selection ratios, and the second mask layer 24 for patterning the first doped semiconductor layer 12 is obtained. It is unnecessary to additionally form other mask materials and other mask deposition procedures so as to obtain the second mask layer 24 on the first regions and the first interval sub-region. In this way, manufacturing cost of the back contact solar cell can be reduced, and a manufacturing process of the back contact solar cell can be simplified. A specific condition of the laser etching process may be set according to an actual application scene, and is not specifically limited herein.

For example, laser used in the laser etching process may be nanosecond laser, picosecond laser, or femtosecond laser. The laser etching process may be greater than or equal to 10 W and less than or equal to 100 W. A diameter of a laser spot may be greater than or equal to 50 µm and less than or equal to 300 µm.

Clearly, when the material of the first doped semiconductor layer includes silicon or the material of the first doped semiconductor layer includes no silicon, the first doped semiconductor layer integrally arranged on the back surface may be formed through processes such as chemical vapor deposition and doping. Then, a mask layer whose material is silicon nitride or another material having a masking function may be formed through processes such as chemical vapor deposition and etching.

In addition, after the second mask layer is formed, part of the first doped semiconductor layer on the second interval sub-regions and the second regions may be selectively removed under the masking action of the mask layer through a wet chemical process, and the recess structures that are concave toward the interior of the silicon substrate relative to the surfaces of the first regions may be formed on the interval regions and the second regions. In this way, high-temperature laser can be prevented from damaging the silicon substrate, and a yield of the back contact solar cell can be improved. In addition, when the recess structures are formed through the wet chemical process, an etching method for the silicon substrate by a wet chemical erosion solution is approximately isotropic etching, such that a length of a suspended end of the first doped semiconductor layer can be increased, and formation of flat surfaces of the first interval sub-regions can be facilitated.

Specifically, a process condition of selectively etching the first doped semiconductor layer may be determined according to an etching process used, the material of the first doped semiconductor layer, and a specification of the formed recess structures, and is not specifically limited herein.

For example, when the wet chemical process is used and the recess structures are formed on the interval regions and the second regions under the masking action of the second mask layer, a process temperature of the wet chemical process may be greater than or equal to 61°C and less than or equal to 83°C. In addition, process time of the wet chemical process may be greater than or equal to 60s and less than or equal to 450s. Further, the wet chemical erosion solution used in the wet chemical process is an alkaline wet chemical erosion solution, and a volume ratio of an alkaline component (for example, NaOH, KOH, etc.) in the alkaline wet chemical erosion solution is greater than or equal to 1% and less than or equal to 15%. For example, the process temperature of the wet chemical process may be 61°C, 70°C, 75°C, 80°C, 83°C, etc. The process time of the wet chemical process may be 60s, 100s, 200s, 300s, 400s, 450s, etc. When the wet chemical erosion solution used in the wet chemical process is the alkaline wet chemical erosion solution, the volume ratio of the alkaline component in the alkaline wet chemical erosion solution may be 1%, 3%, 6%, 9%, 12%, 15%, etc. In this case, the process temperature and the process time of the wet chemical process may influence a specification of the recess structures formed through the wet chemical process and a specification of the suspended end of the first doped semiconductor layer. Based on this, the process temperature of the wet chemical process is within the range, such that a small depth of the recess structure and a small suspension height and length of the suspended end of the first doped semiconductor layer due to a low process temperature can be prevented. In addition, a great depth of the recess structure due to a great process temperature can be prevented. The depth of the recess structure is equal to a depth by which the first interval sub-regions are concave toward the interior of the silicon substrate. Based on this, reference may be made to the above description for beneficial effects of preventing the small depth of the recess structure and the small suspension height and length of the suspended end of the first doped semiconductor layer and preventing the great depth of the recess structure. In addition, beneficial effects of the process time and the volume ratio of the alkaline component within the range are similar to those of enabling the process temperature to be greater than or equal to 65°C and less than or equal to 85°C, and will not be repeated herein.

In addition, a polishing additive is added to the wet chemical erosion solution, such that flatness of a recess bottom surface of the formed recess structures can be improved, and further the passivation effect of the surface passivation layer on the interval regions can be improved. Specifically, a component of the polishing additive and a ratio of the polishing additive to the wet chemical erosion solution may be determined according to an actual application scene, and is not specifically limited herein. For example, the polishing additive may include sodium benzoate, a defoaming agent, a surfactant, etc. A volume ratio of the polishing additive to the wet chemical erosion solution may be greater than or equal to 0.5% and less than or equal to 3%.

It should be noted that, when the manufactured back contact solar cell further includes first passivation layer between the first regions and the first doped semiconductor layer, the manufacturing method for a back contact solar cell further includes the following step: the first passivation layer is formed on the first regions and the first interval sub-regions through deposition and etching processes after the silicon substrate is provided and before the first doped semiconductor layer is formed on the first regions and the first interval sub-region.

Alternatively, as shown in FIG. 6, after the silicon substrate 11 is provided, the first passivation layer 20 integrally arranged on the back surface may be formed through processes such as chemical vapor deposition. Then, as shown in FIG. 9 and FIG. 10, after the second mask layer 24 is formed and the first doped semiconductor layer 12 is selectively etched under the masking action of the second mask layer 24, the first passivation layer 20 is selectively etched. In this case, it is unnecessary to additionally form a corresponding mask layer so as to form the first passivation layer 20 between the first regions 14 and the first doped semiconductor layer 12. In this way, a manufacturing process of the back contact solar cell may be simplified.

Then, after the recess structures are formed, as shown in FIG. 12, the second doped semiconductor layer 13 is deposited on the first doped semiconductor layer 12 and in the recess structures 22. As shown in FIG. 15, a first mask layer 23 is formed on part of the second doped semiconductor layer 13 in the second regions 15.

Specifically, reference may be made to the above description for a material and a thickness of the second doped semiconductor layer, which will not be repeated herein. A material of the first mask layer may be any material having a masking function. In an actual manufacturing process, a formation process and a specific formation procedure of the second doped semiconductor layer and the second mask layer may be determined according to materials of the second doped semiconductor layer and the second mask layer.

For example, when the material of the second doped semiconductor layer includes silicon, the steps that the second doped semiconductor layer is deposited on the first doped semiconductor layer and in the recess structures, and the first mask layer is formed on the part of the second doped semiconductor layer in the second regions may include the following steps: As shown in FIG. 12, a second intrinsic semiconductor layer 27 is deposited on the first doped semiconductor layer 12 and in the recess structures 22. Then, as shown in FIG. 13, doping treatment is conducted on the second intrinsic semiconductor layer, the second doped semiconductor layer 13 is formed on the second intrinsic semiconductor layer, and a second doped silica glass layer 28 integrally arranged is formed on the second doped semiconductor layer 13. Then, as shown in FIG. 14, heat treatment is conducted on part of the second doped silica glass layer on the first regions 14 and the interval regions 16 through a laser etching process, and the first mask layer 23 is formed on part (that is, part not subjected to the heat treatment) of the second doped silica glass layer in the second regions 15. Then, as shown in FIG. 15, the part, subjected to the heat treatment, of the second doped silica glass layer is removed.

Specifically, when the material of the second doped semiconductor layer includes silicon, the material of the second doped semiconductor layer only includes silicon; or the material of the second doped semiconductor layer includes silicon and other semiconductor materials such as germanium-silicon. Further, in an actual manufacturing process, the second intrinsic semiconductor layer integrally arranged on the back surface may be formed through processes such as chemical vapor deposition. Then, doping treatment may be conducted on the second intrinsic semiconductor layer through processes such as diffusion. After the doping treatment, the second doped semiconductor layer can be obtained, and the second doped silica glass layer integrally arranged can be formed on the second doped semiconductor layer. Then, the heat treatment is conducted on part of the second doped silica glass layer on the first regions and the interval regions through the laser etching process. In this case, part, subjected to laser treatment, of the second doped silica glass layer has a lower density and is easy to remove. Part of the second doped silica glass layer on the second regions is not subjected to the laser treatment, had a higher density, and is uneasy to remove. Thus, after the heat treatment, different parts of the second doped silica glass layer have different etching selection ratios, and the first mask layer for patterning the second doped semiconductor layer is obtained. It is unnecessary to additionally form other mask materials and other mask deposition procedures so as to obtain the first mask layer in the second region. In this way, manufacturing cost of the back contact solar cell can be reduced, and a manufacturing process of the back contact solar cell can be simplified. Reference may be made to the above description for a specific condition of the laser etching process, which will not be specifically limited herein.

Clearly, when the material of the second doped semiconductor layer includes silicon or the material of the second doped semiconductor layer includes no silicon, the second doped semiconductor layer integrally arranged on the back surface may be formed through processes such as chemical vapor deposition and doping. Then, the first mask layer whose material is silicon nitride or another material having a masking function may be formed through processes such as chemical vapor deposition and etching.

Then, as shown in FIG. 16, part of the second doped semiconductor layer 13 on the first regions 14 and the interval regions 16 is selectively removed under the masking action of the first mask layer 23, and surfaces of the second interval sub-regions 18 are concave toward the interior of the silicon substrate 11 relative to surfaces of the first interval sub-regions 17.

In an actual manufacturing process, through the wet chemical process, the part of the second doped semiconductor layer on the first regions and the interval regions is selectively removed under the masking action of the first mask layer, and the surfaces of the second interval sub-regions are concave toward the interior of the silicon substrate relative to the surface of the first interval sub-region. In this way, high-temperature laser can be prevented from damaging the silicon substrate, and a yield of the back contact solar cell can be improved. Specifically, a process condition of the operation may be determined according to a used etching process, the material of the second doped semiconductor layer, and a depth by which the surfaces of the second interval sub-regions are concave toward the interior of the silicon substrate relative to the surfaces of the first interval sub-regions, and is not specifically limited herein.

For example, when the wet chemical process is used, the part of the second doped semiconductor layer on the first regions and the interval regions is selectively removed under the masking action of the first mask layer, and the surface of the second interval sub-regions is concave toward the interior of the silicon substrate relative to the surfaces of the first interval sub-regions and forms a textured surface, the process temperature of the wet chemical process may be greater than or equal to 61°C and less than or equal to 83°C. In addition, the process time of the wet chemical process may be greater than or equal to 100s and less than or equal to 500s. Further, the wet chemical erosion solution used in the wet chemical process may be the alkaline wet chemical erosion solution, and the volume ratio of the alkaline component (for example, NaOH, KOH, etc.) in the alkaline wet chemical erosion solution is greater than or equal to 1% and less than or equal to 3.5%. For example, the process temperature of the wet chemical process may be 61°C, 70°C, 75°C, 80°C, 83°C, etc. The process time of the wet chemical process may be 100s, 200s, 300s, 400s, 500s, etc. When the wet chemical erosion solution used in the wet chemical process is the alkaline wet chemical erosion solution, the volume ratio of the alkaline component in the alkaline wet chemical erosion solution may be 1%, 1.5%, 2%, 2.5%, 3%, 3.5%, etc. In this case, the process temperature and the process time of the wet chemical process may influence the depth by which the surfaces of the second interval sub-regions are concave toward the interior of the silicon substrate relative to the surfaces of the first interval sub-regions through the wet chemical process. Based on this, the process temperature of the wet chemical process is within the range, such that the small depth by which the surfaces of the second interval sub-regions are concave toward the interior of the silicon substrate relative to the surfaces of the first interval sub-regions due to the small process temperature can be prevented. In addition, the great depth by which the surfaces of the second interval sub-regions are concave toward the interior of the silicon substrate relative to the surfaces of the first interval sub-regions due to the great process temperature can be prevented. Reference may be made to the above description for beneficial effects of preventing the small and great depths by which the surfaces of the second interval sub-regions are concave toward the interior of the silicon substrate relative to the surfaces of the first interval sub-regions. In addition, beneficial effects of the process time and the volume ratio of the alkaline component within the range are similar to those of enabling the process temperature to be greater than or equal to 61°C and less than or equal to 83°C, and will not be repeated herein.

In addition, as shown in FIG. 16, under the masking action of the first mask layer 23, the surfaces of the second interval sub-regions 18 may be textured while the surfaces of the second interval sub-regions 18 are concave toward the interior of the silicon substrate 11 relative to the surfaces of the first interval sub-regions 17. In this case, the surfaces of the second interval sub-regions may be formed into the textured surface by adding a texturing additive to the wet chemical erosion solution used in the wet chemical process. Specifically, a type of the texturing additive and a volume ratio of the texturing additive in the wet chemical erosion solution may be determined according to a size of a textured structure and an actual application scene. For example, the texturing additive may include sodium benzoate, a defoaming agent, a surfactant, etc. A volume ratio of the texturing additive in the wet chemical erosion solution may be greater than or equal to 0.5% and less than or equal to 2%. In this case, the volume ratio of the texturing additive is within the range, such that a requirement of using a thick silicon substrate to manufacture the back contact solar cell due to a great volume ratio can be prevented, and thinning production can be facilitated. An undesirable light trapping effect of the surfaces of the second interval sub-regions due to a small size of a textured structure formed on the surfaces of the second interval sub-regions because of the small volume ratio can be prevented, more light can be ensured to be refracted into the silicon substrate of via the surfaces of the second interval sub-regions, and further photoelectric conversion efficiency of the back contact solar cell can be improved.

It should be noted that components of the texturing additive and the polishing additive may be identical, and have different effects under conditions of different process time, process temperatures, and different volume ratios.

It should be noted that when the manufactured back contact solar cell further includes a second passivation layer between the second regions and the second doped semiconductor layer, the second passivation layer may be deposited on the first doped semiconductor layer and in recess structures after the recess structures that are concave toward the interior of the silicon substrate are formed on the interval regions and the second regions and before the second doped semiconductor layer is deposited on the first doped semiconductor layer and in the recess structures. As shown in FIG. 15, the second passivation layer 21 is deposited on the first doped semiconductor layer 12 and in the recess structures 22. Specifically, the second passivation layer 21 may be formed through processes such as chemical vapor deposition. Reference may be made to the above description for a material and a thickness of the second passivation layer 21.

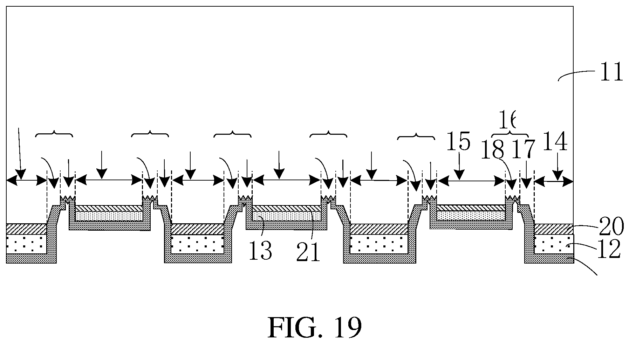

Specifically, part of the second passivation layer on the first regions and the interval regions is selectively removed under the masking action of the first mask layer after the part of the second doped semiconductor layer on the first regions and the interval regions is selectively removed under the masking action of the first mask layer and before the surfaces of the second interval sub-regions are concave toward the interior of the silicon substrate relative to the surfaces of the first interval sub-regions. As shown in FIG. 18 and FIG. 19, through the wet chemical process, the part of the second passivation layer 21 on the first regions 14 and the interval regions 16 may be selectively removed under the masking action of the first mask layer 23.

Then, as shown in FIG. 17 and FIG. 18, a suspended end of the first doped semiconductor layer 12 is removed. The first mask layer is removed.

Specifically, the suspended end of the first doped semiconductor layer may be removed through ultrasonic cleaning or other methods. A process condition corresponding to the ultrasonic cleaning method may be determined according to a specification of the suspended end of the first doped semiconductor layer, the material of the first doped semiconductor layer and actual needs, and is not specifically limited herein. For example, ultrasonic frequency may be greater than 30 KHz, and a cleaning temperature may be greater than or equal to 20°C and less than or equal to 80°C.

Then, the first mask layer may be removed through the wet chemical process. In addition, a sequence of removing the first mask layer and removing the suspended ends of the first doped semiconductor layer is not specifically limited in the embodiment of the present application. After the first mask layer is removed, the suspended ends of the first doped semiconductor layer may be removed. Alternatively, the suspended ends of the first doped semiconductor layer may be removed, and then the first mask layer may be removed.

Then, as shown in FIG. 19, the surface passivation layer 19 covering the first doped semiconductor layer 12, the second doped semiconductor layer 13 and the interval regions 16 are formed. Specifically, the surface passivation layer 19 may be formed through physical vapor deposition or chemical vapor deposition. Reference may be made to the above description for a material and a thickness of the surface passivation layer 19.

Reference may be made to analysis of beneficial effects of the first aspect and various implementations of the first aspect for beneficial effects of the second aspect and various implementations of the second aspect in the embodiments of the present application, which will not be repeated herein

In addition, an embodiment of the present application further provides a comparative embodiment and an embodiment to describe a manufacturing process and working performance of the back contact solar cell provided by the embodiment of the present application. Table 1 shows test results of the back contact solar cells corresponding to Embodiment 1 and Comparative embodiment 1.

### Embodiment 1

Step one, a monocrystalline silicon wafer is subjected to alkali polishing with a 15% alkali solution, so as to form a smooth and clean silicon surface.

Step two, deposition of a tunneling oxide layer and an intrinsic polycrystalline silicon layer is sequentially conducted on a surface of the monocrystalline silicon wafer. A thickness of the tunneling oxide layer is 1.8 nm, and a thickness of the intrinsic polycrystalline silicon layer is 350 nm.

Step three, boron doping treatment is conducted on the deposited intrinsic polycrystalline silicon layer, such that the intrinsic polycrystalline silicon layer is formed into a P-type doped polycrystalline silicon layer. A borosilicate glass layer is formed on the P-type doped polycrystalline silicon layer. A doping concentration of boron is 8×10¹⁹/cm³.

Step four, heat treatment is conducted on the borosilicate glass layer through a laser etching process, so as to prepare a mask layer having a specific pattern. Laser may be generated by a picosecond laser, processing power of the laser may be 40 W, and a diameter of a spot of the laser is 200 µm.

Step five, part of the P-type doped polycrystalline silicon layer is selectively removed under a masking action of the mask layer. Surface etching treatment is conducted on the monocrystalline silicon wafer, such that recess structures are formed, and an end of the P-type doped polycrystalline silicon layer adjacent to the recess structures are suspended. A main component of a used erosion solution includes alkali and a polishing additive. An alkali concentration of the erosion solution is 5%, an erosion temperature is 82°C, process time is 300s, a volume ratio of the polishing additive is 2%, and main components of the polishing additive include sodium benzoate, a defoaming agent, and a surfactant.

Step six, the tunneling oxide layer and an N-type doped polycrystalline silicon layer sequentially stacked are formed on a recess bottom of the recess structure. A thickness of the N-type doped polycrystalline silicon layer is greater than or equal to 150 nm and less than or equal to 180 nm. A thickness of the tunneling oxide layer is greater than or equal to 0.5 nm and less than or equal to 3 nm.

Step seven, part of a back surface between the N-type doped polycrystalline silicon layer and the P-type doped polycrystalline silicon layer is textured. (It should be noted that, Embodiment 1 is described with an example in which a surface of the part (that is, the second interval sub-regions described above) of the back surface between the N-type doped polycrystalline silicon layer and the P-type doped polycrystalline silicon layer is a textured surface, and did not indicate that the surface of the part of the back surface between the N-type doped polycrystalline silicon layer and the P-type doped polycrystalline silicon layer may only be a textured surface. When the surface of the part of the back surface between the N-type doped polycrystalline silicon layer and the P-type doped polycrystalline silicon layer is a flat surface, operation corresponding to step seven may be omitted.)

Step eight, the suspended end of the P-type doped polycrystalline silicon layer is removed.

### Comparative embodiment 1

Except step four, step five, and step eight, other steps of the manufacturing method corresponding to Comparative embodiment 1 are identical to those of the manufacturing flow of Embodiment 1. In the manufacturing method provided by Comparative embodiment 1, after boron doping treatment is conducted on a deposited intrinsic polycrystalline silicon layer and before a tunneling oxide layer and an N-type doped polycrystalline silicon layer sequentially stacked are formed on a recess bottom of recess structures, a borosilicate glass layer is removed, the tunneling oxide layer and the doped polysilicon layer formed are selectively etched directly through a laser etching process, and the recess structures having a side wall arranged perpendicular to a horizontal plane are formed in a silicon substrate.

**Table 1 Test results of back contact solar cells corresponding to Embodiment 1 and Comparative embodiment 1**

| Item | Efficiency (%) | Open-circuit voltage (mV) | Short-circuit current (A) | Filling factor (%) |
|---|---|---|---|---|
| Comparative embodiment 1 | 25.424 | 735.7 | 14.067 | 81.82 |
| Embodiment 1 | 25.473 | 736.3 | 14.072 | 81.88 |

It may be seen from data shown in Table 1 that, in the back contact solar cell formed through the manufacturing method provided by Embodiment 1, the passivation effect of the surface passivation layer on the interval regions is better, such that the back contact solar cell has higher working efficiency, open-circuit voltage, short-circuit current, and filling factors than the back contact solar cell obtained through the manufacturing method corresponding to Comparative embodiment 1. That is, the back contact solar cell provided by the embodiment of the present application has higher working performance.

In the above description, technical details such as patterning and etching of each layer are not described in details. However, those skilled in the art should understand that layers, regions, etc. having required shapes may be formed by various technical means. In addition, in order to form an identical structure, those skilled in the art may design a method that is not exactly identical to the method described above. In addition, each embodiment is described separately above, which does not indicate that measures in each embodiment cannot be used in combination.

The embodiments of the present application are described above. However, the embodiments are merely used for description and are not intended to limit the scope of the present application. The scope of the present application is limited by the appended claims and their equivalents. Those skilled in the art may make various replacements and modifications without departing from the scope of the present application, and the replacements and modifications should fall within the scope of the present application.

## Claims

1. A back contact solar cell, comprising:
a silicon substrate;
a first doped semiconductor layer and a second doped semiconductor layer that are alternately distributed at intervals on a back surface of the silicon substrate in a direction parallel to the silicon substrate, a conduction type of the first doped semiconductor layer being opposite to that of the second doped semiconductor layer; on the back surface of the silicon substrate, regions corresponding to the first doped semiconductor layer being first regions, regions corresponding to the second doped semiconductor layer being second regions, and regions between the first regions and the adjacent second regions being interval regions; in an arrangement direction of the first regions and the second regions, the interval regions adjacent to the first doped semiconductor layer being first interval sub-regions, and the other interval regions being second interval sub-regions; surfaces of the first interval sub-regions and surfaces of the second regions that are concave toward an interior of the silicon substrate relative to surfaces of the first regions, and surfaces of the second interval sub-regions that are concave toward the interior of the silicon substrate relative to the surfaces of the first interval sub-regions; the surfaces of the first interval sub-regions being flat surfaces; and
a surface passivation layer covering the first doped semiconductor layer, the second doped semiconductor layer, and the interval regions.

2. The back contact solar cell according to claim 1, wherein in the arrangement direction of the first regions and the second regions, a length of the interval region is greater than or equal to 20 µm and less than or equal to 110 µm; and/or
in the arrangement direction of the first regions and the second regions, a length of the first interval sub-region is greater than or equal to 1000 nm and less than or equal to 3000 nm.

3. The back contact solar cell according to claim 1, wherein the surfaces of the first interval sub-regions are flush with the surfaces of the second regions; and/or
a depth by which the surfaces of the first interval sub-regions are concave toward the interior of the silicon substrate relative to the surfaces of the first regions is greater than or equal to 500 nm and less than or equal to 2500 nm.

4. The back contact solar cell according to claim 1, wherein the surfaces of the second interval sub-regions are textured surfaces; and/or
a depth by which the surfaces of the second interval sub-regions are concave toward the interior of the silicon substrate relative to the surfaces of the first regions is greater than or equal to 3 µm and less than or equal to 5 µm.

5. The back contact solar cell according to claim 1, wherein a surface of at least part of a side wall of the interval region adjacent to the first doped semiconductor layer is arranged obliquely relative to a horizontal plane, and a cross-sectional area of at least part of the interval region gradually increases in a direction from a light receiving surface to the back surface;
and/or
in the side wall of the interval regions adjacent to the first doped semiconductor layer, a surface of part of the side wall close to the back surface is arranged perpendicular to the horizontal plane.

6. The back contact solar cell according to claim 1, further comprising: a first passivation layer located between the first regions of the silicon substrate and the first doped semiconductor layer;
and/or
a second passivation layer located between the second regions of the silicon substrate and the second doped semiconductor layer.

7. The back contact solar cell according to claim 6, wherein when the back contact solar cell comprises the first passivation layer and the first passivation layer is a tunneling passivation layer, the first doped semiconductor layer is a doped polycrystalline silicon layer; and/or
when the back contact solar cell comprises the second passivation layer and the second passivation layer is a tunneling passivation layer, the second doped semiconductor layer is a doped polycrystalline silicon layer.

8. A manufacturing method for a back contact solar cell, comprising the following steps:
providing a silicon substrate, first regions and second regions alternately distributed at intervals and interval regions located between the first regions and the adjacent second regions being provided on a back surface of the silicon substrate in a direction parallel to the silicon substrate; and in an arrangement direction of the first regions and the second regions, the interval regions adjacent to the first regions being first interval sub-regions, and the other interval regions being second interval sub-regions;
forming a first doped semiconductor layer on the first regions and the first interval sub-regions; and forming recess structures that are concave toward an interior of the silicon substrate on the interval regions and the second regions, and a suspending end of the first doped semiconductor layer adjacent to the interval regions, recess bottoms of the recess structures being flat surfaces;
depositing a second doped semiconductor layer on the first doped semiconductor layer and in the recess structures, and forming a first mask layer on part of the second doped semiconductor layer in the second region;
selectively removing part of the second doped semiconductor layer on the first regions and the interval regions under a masking action of the first mask layer, and causing surfaces of the second interval sub-regions that are concave toward the interior of the silicon substrate relative to surfaces of the first interval sub-regions;
removing a suspended end of the first doped semiconductor layer; removing the first mask layer; and
forming a surface passivation layer covering the first doped semiconductor layer, the second doped semiconductor layer, and the interval regions.

9. The manufacturing method for a back contact solar cell according to claim 8, wherein after the providing a silicon substrate, and before the depositing a second doped semiconductor layer on the first doped semiconductor layer and in the recess structures, the manufacturing method for a back contact solar cell further comprises the following steps:
forming the first doped semiconductor layer integrally arranged on the back surface of the silicon substrate, and arranging a second mask layer on part of the first doped semiconductor layer on the first regions and the first interval sub-regions;
selectively removing part of the first doped semiconductor layer on the second interval sub-regions and the second regions under a masking action of the second mask layer; and
forming the recess structures on the interval regions and the second regions under the masking action of the second mask layer.

10. The manufacturing method for a back contact solar cell according to claim 9, wherein a material of the first doped semiconductor layer comprises silicon; and
the forming the first doped semiconductor layer integrally arranged on the back surface of the silicon substrate, and arranging a second mask layer on part of the first doped semiconductor layer on the first regions and the first interval sub-regions comprise:
forming a first intrinsic semiconductor layer integrally arranged on the back surface of the silicon substrate;
conducting doping treatment on the first intrinsic semiconductor layer, forming the first doped semiconductor layer on the first intrinsic semiconductor layer, and forming a first doped silica glass layer integrally arranged on the first doped semiconductor layer;
conducting heat treatment on part of the first doped silica glass layer on the second interval sub-regions and the second regions through a laser etching process, and forming the second mask layer on part, not subjected to the heat treatment, of the first doped silica glass layer; and
removing part, subjected to the heat treatment, of the first doped silica glass layer.

11. The manufacturing method for a back contact solar cell according to claim 9, wherein through a wet chemical process, the recess structures are formed on the interval regions and the second regions under the masking action of the second mask layer, wherein
a process temperature of the wet chemical process is greater than or equal to 61°C and less than or equal to 83°C; and/or, process time of the wet chemical process is greater than or equal to 60s and less than or equal to 450s; and/or, a wet chemical erosion solution used in the wet chemical process is an alkaline wet chemical erosion solution, and a volume ratio of an alkaline component in the alkaline wet chemical erosion solution is greater than or equal to 1% and less than or equal to 15%; and/or, a wet chemical erosion solution used in the wet chemical process contains a polishing additive, and a volume ratio of the polishing additive in the wet chemical erosion solution is greater than or equal to 0.5% and less than or equal to 3%.

12. The manufacturing method for a back contact solar cell according to claim 8, wherein under the masking action of the first mask layer, the surfaces of the second interval sub-regions are textured while the surfaces of the second interval sub-regions are concave toward the interior of the silicon substrate relative to the surfaces of the first interval sub-regions.

13. The manufacturing method for a back contact solar cell according to any one of claims 8-12, wherein a material of the second doped semiconductor layer comprises silicon; and
the depositing a second doped semiconductor layer on the first doped semiconductor layer and in the recess structures, and forming a first mask layer on part of the second doped semiconductor layer on the second regions comprise:
depositing a second intrinsic semiconductor layer on the first doped semiconductor layer and in the recess structures;
conducting doping treatment on the second intrinsic semiconductor layer, forming the second doped semiconductor layer on the second intrinsic semiconductor layer, and forming a second doped silica glass layer integrally arranged on the second doped semiconductor layer;
conducting heat treatment on part of the second doped silica glass layer on the first regions and the interval regions through a laser etching process, and forming the first mask layer on part of the second doped silica glass layer on the second regions; and
removing part, subjected to the heat treatment, of the second doped silica glass layer.

14. The manufacturing method for a back contact solar cell according to any one of claims 8-12, wherein through the wet chemical process, part of the second doped semiconductor layer on the first regions and the interval regions is selectively removed under the masking action of the first mask layer, and the surfaces of the second interval sub-regions are concave toward the interior of the silicon substrate relative to the surfaces of the first interval sub-regions, wherein
a process temperature of the wet chemical process is greater than or equal to 61°C and less than or equal to 83°C; and/or, process time of the wet chemical process is greater than or equal to 100s and less than or equal to 500s; and/or, a wet chemical erosion solution used in the wet chemical process is an alkaline wet chemical erosion solution, and a volume ratio of an alkaline component in the alkaline wet chemical erosion solution is greater than or equal to 1% and less than or equal to 3.5%; and/or, a wet chemical erosion solution used in the wet chemical process contains a texturing additive, and a volume ratio of the texturing additive in the wet chemical erosion solution is greater than or equal to 0.5% and less than or equal to 2%.

15. The manufacturing method for a back contact solar cell according to any one of claims 8-12, further comprising: forming a first passivation layer, which comprises the following step: forming the first passivation layer on the first regions and the first interval sub-regions after the providing a silicon substrate and before the forming a first doped semiconductor layer on the first regions and the first interval sub-regions.

16. The manufacturing method for a back contact solar cell according to any one of claims 8-12, further comprising: forming a second passivation layer between the second regions and the second doped semiconductor layer, which comprises the following steps:
depositing the second passivation layer on the first doped semiconductor layer and in recess structures after the forming the recess structures that are concave toward an interior of the silicon substrate on the interval regions and the second regions and before the depositing a second doped semiconductor layer on the first doped semiconductor layer and in the recess structures; and
selectively removing part of the second passivation layer on the first regions and the interval regions under the masking action of the first mask layer after the selectively removing part of the second doped semiconductor layer on the first regions and the interval regions under a masking action of the first mask layer and before the causing surfaces of the second interval sub-regions that are concave toward the interior of the silicon substrate relative to surfaces of the first interval sub-regions.
